# EUROPÄISCHE PATENTANMELDUNG

(11) **EP 4 468 576 A1**
(43) Veröffentlichungstag der Anmeldung: **27.11.2024**
(21) Anmeldenummer: 24175453.0
(22) Anmeldetag: 13.05.2024
(51) Int. Cl.: H02K 11/33, H02K 1/18, H02K 5/128, H02K 7/14, H02K 9/22, F04D 13/06, F04D 29/048, F04D 29/42, F04D 29/58, F04D 1/00, H02K 1/14, H02K 7/09

(54) **ELEKTROMAGNETISCHER DREHANTRIEB UND ZENTRIFUGALPUMPE**

(30) Priorität: 22.05.2023 EP 23174493
(71) Anmelder: Levitronix GmbH, 8048 Zürich (CH)
(72) Erfinder: Stettler, Marcel, 4800 Zofingen (CH); Steinert, Daniel, 8180 Bülach (CH); Barletta, Natale, 8048 Zürich (CH)
(74) Vertreter: IPS Irsch AG

(57) **Zusammenfassung**

Es wird ein elektromagnetischer Drehantrieb vorgeschlagen, der als Tempelmotor ausgestaltet ist, und eine Motoreinheit (30) sowie eine Kontrolleinheit (40) umfasst, wobei die Motoreinheit (30) in einem Motorgehäuse (20) angeordnet ist, welches eine Ausnehmung (210) zum Aufnehmen eines ring- oder scheibenförmigen magnetisch wirksamen Kerns (31) eines Rotors (3) aufweist, wobei die Motoreinheit (30) einen Stator (2) umfasst, welcher als Lager- und Antriebsstator ausgestaltet ist, mit welchem der Rotor (3) im Betriebszustand berührungslos magnetisch um eine Solldrehachse antreibbar ist, die eine axiale Richtung (A) definiert, und mit welchem der Rotor (3) berührungslos magnetisch bezüglich des Stators (2) lagerbar ist, wobei der Rotor (3) in einer zur axialen Richtung (A) senkrechten radialen Ebene aktiv magnetisch gelagert ist, wobei der Stator (2) eine Mehrzahl von Spulenkernen (25) aufweist, von denen jeder einen Längsschenkel (26) umfasst, welcher sich von einem ersten Ende in axialer Richtung (A) bis zu einem zweiten Ende erstreckt, sowie einen Querschenkel (27), welcher an dem zweiten Ende des Längsschenkels (26) und in der radialen Ebene angeordnet ist, und welcher sich von dem Längsschenkel (26) in einer radialen Richtung erstreckt, wobei die Spulenkerne (25) bezüglich einer Umfangsrichtung um die Ausnehmung (210) herum angeordnet sind, und wobei an jedem Längsschenkel (26) mindestens eine konzentrierte Wicklung (61) vorgesehen ist, welche den jeweiligen Längsschenkel (26) umgibt, und wobei die Kontrolleinheit (40) für die Ansteuerung und die Versorgung der Wicklungen (61) mit elektrischer Energie ausgestaltet ist. Bezüglich der axialen Richtung (A) ist zwischen der Motoreinheit (30) und der Kontrolleinheit (40) ein thermisches Trennelement (8a; 8b) angeordnet, welches an der Motoreinheit (30) und an der Kontrolleinheit (40) anliegt, und welches einen direkten Wärmefluss aus der Motoreinheit (30) in die Kontrolleinheit (40) reduziert. Durch die Erfindung wird ferner eine Zentrifugalpumpe mit einem solchen Drehantrieb (1) vorgeschlagen.

## Beschreibung

Die Erfindung betrifft einen elektromagnetischen Drehantrieb gemäss dem Oberbegriff des unabhängigen Patentanspruchs und eine Zentrifugalpumpe mit einem solchen elektromagnetischen Drehantrieb.

Es sind elektromagnetische Drehantriebe bekannt, die nach dem Prinzip des lagerlosen Motors ausgestaltet sind und betrieben werden. Mit dem Begriff lagerloser Motor ist dabei ein elektromagnetischer Drehantrieb gemeint, bei welchem ein Rotor vollkommen magnetisch bezüglich des Stators lagerbar ist, wobei keine separaten magnetischen Lager vorgesehen sind. Der Stator ist dazu als Lager- und Antriebsstator ausgestaltet, der sowohl Stator des elektrischen Antriebs als auch Stator der magnetischen Lagerung ist. Mit den elektrischen Wicklungen des Stators lässt sich ein magnetisches Drehfeld erzeugen, welches zum einen ein Drehmoment auf den Rotor ausübt, das dessen Rotation um eine Solldrehachse bewirkt, und welches zum anderen eine beliebig einstellbare Querkraft auf den Rotor ausübt, sodass dessen radiale Position aktiv steuerbar bzw. regelbar ist. Somit sind drei Freiheitsgrade des Rotors aktiv regelbar, nämlich seine Rotation sowie seine radiale Position (zwei Freiheitsgrade). Bezüglich dreier weiterer Freiheitsgrade, nämlich seiner Position in axialer Richtung und Verkippungen bezüglich der zur Solldrehachse senkrechten radialen Ebene (zwei Freiheitsgrade), ist der Rotor passiv magnetisch, das heisst nicht ansteuerbar, durch Reluktanzkräfte gelagert bzw. stabilisiert. Das Nichtvorhandensein eines separaten magnetischen Lagers bei vollständiger magnetischer Lagerung des Rotors ist die Eigenschaft, welcher der lagerlose Motor seinen Namen verdankt. In dem Lager- und Antriebsstator lässt sich die Lagerfunktion nicht von der Antriebsfunktion separieren.

Ein solcher lagerloser Motor hat sich in einer Vielzahl von Anwendungen bewährt. Aufgrund der Abwesenheit von mechanischen Lagern eignet sich der lagerlose Motor insbesondere für Pump-, Misch- oder Rührvorrichtungen, mit denen sehr empfindliche Substanzen gefördert werden, beispielsweise Blutpumpen, oder bei denen sehr hohe Anforderungen an die Reinheit gestellt werden, beispielsweise in der pharmazeutischen Industrie oder in der biotechnologischen Industrie, oder mit denen abrasive oder aggressive Substanzen gefördert werden, welche mechanische Lager sehr schnell zerstören würden, beispielsweise Pumpen oder Mischer für Slurry, Schwefel-, Phosphorsäure oder andere Chemikalien in der Halbleiterindustrie.

Ein weiterer Vorteil des Prinzips des lagerlosen Motors ergibt sich bei der Ausgestaltung des Rotors als Integralrotor, der sowohl der Rotor des elektromagnetischen Drehantriebs ist als auch der Rotor der Pumpe. Neben der berührungslosen magnetischen Lagerung resultiert hier der Vorteil einer sehr kompakten und platzsparenden Ausgestaltung.

Zudem erlaubt das Prinzip des lagerlosen Motors auch Ausgestaltungen, beispielsweise von Zentrifugalpumpen, bei denen der Rotor sehr leicht vom Stator trennbar ist. Dies ist ein sehr grosser Vorteil, weil damit beispielsweise der Rotor bzw. die Pumpeneinheit, welche den Rotor umfasst, als Einmalteil für den Einmalgebrauch ausgestaltet werden kann. Solche Einmalanwendungen ersetzen heute häufig Prozesse, bei denen früher aufgrund der sehr hohen Reinheitsanforderungen alle diejenigen Komponenten, welche im Prozess mit den zu behandelnden Substanzen in Kontakt kommen, aufwändig gereinigt und sterilisiert werden müssen, beispielsweise mittels Dampfsterilisierung. Bei der Ausgestaltung für den Einmalgebrauch werden diejenigen Komponenten, welche mit den zu behandelnden Substanzen in Kontakt kommen, nur genau einmal verwendet und dann bei der nächsten Anwendung durch neue, das heisst ungebrauchte, Einmalteile ersetzt.

Als Beispiele seien hier die Pharmaindustrie und die biotechnologische Industrie genannt. Hier werden häufig Lösungen und Suspensionen hergestellt, die eine sorgfältige und schonende Förderung von Substanzen verlangen.

Eine vorteilhafte und an sich bekannte Ausführungsform eines elektromagnetischen Drehantriebs, der nach dem Prinzip des lagerlosen Motors ausgestaltet werden kann, ist die Ausführung als Tempelmotor, die beispielsweise in der EP-A-3 232 549 offenbart wird. Auf die Ausgestaltung als Tempelmotor bezieht sich auch die vorliegende Erfindung.

Das Charakteristische eines Tempelmotors ist es, dass der Stator eine Mehrzahl von Spulenkernen aufweist, von denen jeder einen Längsschenkel umfasst, der sich im Wesentlichen parallel zur axialen Richtung erstreckt. Mit der axialen Richtung ist dabei diejenige Richtung gemeint, welche durch die Solldrehachse des Rotors definiert ist, also die Drehachse, um welche der Rotor im Betriebszustand rotiert, wenn er in der radialen Ebene, die senkrecht zur axialen Richtung liegt, bezüglich des Stators in einer zentrierten und unverkippten Position ist. Jeder Längsschenkel erstreckt sich von einem ersten Ende in axialer Richtung bis zu einem zweiten Ende. Jeder Spulenkern umfasst zusätzlich zu dem Längsschenkel einen Querschenkel, welcher jeweils an dem zweiten Ende des Längsschenkels vorgesehen ist, und welcher sich in radialer Richtung nach innen erstreckt, also im Wesentlichen rechtwinklig zum Längsschenkel. Die Spulenkerne haben jeweils die Form eines L, wobei die Querschenkel die kurzen Schenkel des L bilden. Der Rotor ist dann zwischen den Querschenkeln angeordnet.

Die Mehrzahl der Längsschenkel, die sich in axialer Richtung erstrecken und an die Säulen eines Tempels erinnern, hat dem Tempelmotor seinen Namen gegeben.

In einer Ausführungsform hat der Tempelmotors beispielsweise sechs Spulenkerne, die kreisförmig und äquidistant um den Rotor herum angeordnet sind (Innenläufer). Die ersten Enden der Längsschenkel sind in Umfangsichtung durch einen Rückschluss verbunden, welcher der magnetischen Flussführung dient. Der Rotor umfasst einen magnetisch wirksamen Kern, beispielsweise eine permanentmagnetische Scheibe oder einen permanentmagnetischen Ring, der zwischen den radial innenliegenden Enden der Querschenkel angeordnet ist und im Betriebszustand um die axiale Richtung rotiert, wobei der Rotor berührungslos magnetisch angetrieben und berührungslos magnetisch bezüglich des Stators gelagert ist.

Es sind auch solche Ausgestaltungen des Tempelmotors bekannt, bei denen der magnetisch wirksame Kern permanentmagnetfrei, also ohne Permanentmagnete ausgestaltet ist. Der magnetisch wirksame Kern des Rotors ist dann beispielsweise ferromagnetisch ausgestaltet und besteht beispielsweise aus Eisen, Nickel-Eisen, Kobalt-Eisen, Silizium-Eisen, Mu-Metall oder einem anderen ferromagnetischen Werkstoff.

Ferner sind Ausgestaltungen möglich, bei denen der magnetisch wirksame Kern des Rotors sowohl ferromagnetische Materialien als auch permanentmagnetische Materialien umfasst. Beispielsweise können Permanentmagnete in einen ferromagnetischen Grundkörper eingelegt bzw. eingesetzt werden. Solche Ausgestaltungen sind z.B. vorteilhaft, wenn man bei grossen Rotoren die Kosten durch Einsparen von permanentmagnetischem Material reduzieren will.

Um die für den magnetischen Antrieb und die magnetische Lagerung des Rotors notwendigen elektromagnetischen Drehfelder zu erzeugen, tragen die Längsschenkel Wicklungen. Die Wicklungen sind beispielsweise so ausgestaltet, dass um jeden Längsschenkel herum eine konzentrierte Wicklung gewickelt ist, das heisst, die Spulenachse jeder konzentrierten Wicklung erstreckt sich jeweils in axialer Richtung. Dabei ist es typisch für den Tempelmotor, dass die Spulenachsen der konzentrierten Wicklungen parallel zur Solldrehachse verlaufen und, dass die konzentrierten Wicklungen nicht in der radialen Ebene angeordnet sind, in welcher der Rotor bzw. der magnetisch wirksame Kern des Rotors im Betriebszustand gelagert wird.

Bei einer heute häufig verwendeten Ausgestaltung für industrielle Anwendungen ist die Motoreinheit, welche den Lager- und Antriebsstator zum Antreiben und Lagern des Rotors umfasst, räumlich von einer Kontrolleinheit getrennt, welche die Leistungselektronik für die Ansteuerung und die Versorgung der Wicklungen des Stators umfasst, wie zum Beispiel Stromrichter oder Umrichter zur Bereitstellung des in die Wicklungen einzuprägenden Stroms oder Leistungsschalter, mit denen die Wicklungen angesteuert werden. Die Kontrolleinheit ist dann üblicherweise räumlich getrennt von der Motoreinheit angeordnet und über Motorkabel und Sensorkabel mit der Motoreinheit verbunden. Hieraus resultiert ein grosser Platzbedarf und eine hohe Komplexität der Installation, beispielsweise wegen der Verkabelung zwischen der Motoreinheit und der Kontrolleinheit. Diese Verkabelung stellt auch einen Kostenfaktor da. Zudem kann die Übertragung beispielsweise von Sensorsignalen zwischen der Motoreinheit und der Kontrolleinheit störanfällig sein.

Es sind auch schon Versuche gemacht worden, die Kontrolleinheit möglichst nahe an der Motoreinheit anzuordnen. Hierbei ergeben sich aber erhebliche thermische Probleme, weil sowohl von der Motoreinheit als auch von der Kontrolleinheit grosse Wärmemengen produziert werden, die sehr schwierig abzuführen sind, ohne dass es zu einer starken thermischen Wechselwirkung zwischen der Motoreinheit und der Kontrolleinheit kommt.

Die in der Motoreinheit während des Betriebs generierte Wärme beruht insbesondere auf Eisen- und Kupferverlusten. In der Kontrolleinheit ist es insbesondere die Leistungselektronik, beispielsweise die Umrichter oder die Gleichrichter, welche im Betrieb Wärme generiert. Sind daher die Motoreinheit und die Kontrolleinheit räumlich nahe beieinander angeordnet, so besteht die Gefahr, dass die im Betrieb generierte Wärme nicht ausreichend gut abgeführt werden kann, was insbesondere zur Überhitzung der elektronischen Komponenten führen kann, wodurch deren Lebensdauer deutlich reduziert wird.

Es ist daher eine Aufgabe der Erfindung, einen elektromagnetischen Drehantrieb vorzuschlagen, der als Tempelmotor ausgestaltet ist, und welcher eine besonders kompakte Ausgestaltung aufweist, wobei die Kontrolleinheit gegen eine Überhitzung geschützt ist. Ferner ist es eine Aufgabe der Erfindung, eine Zentrifugalpumpe mit einem solchen Drehantrieb vorzuschlagen.

Der diese Aufgabe lösende Gegenstand der Erfindung ist durch die Merkmale des unabhängigen Patentanspruchs gekennzeichnet.

Erfindungsgemäss wird also ein elektromagnetischer Drehantrieb vorgeschlagen, der als Tempelmotor ausgestaltet ist, und eine Motoreinheit sowie eine Kontrolleinheit umfasst, wobei die Motoreinheit in einem Motorgehäuse angeordnet ist, welches eine Ausnehmung zum Aufnehmen eines ring- oder scheibenförmigen magnetisch wirksamen Kerns eines Rotors aufweist, wobei die Motoreinheit einen Stator umfasst, welcher als Lager- und Antriebsstator ausgestaltet ist, mit welchem der Rotor im Betriebszustand berührungslos magnetisch um eine Solldrehachse antreibbar ist, die eine axiale Richtung definiert, und mit welchem der Rotor berührungslos magnetisch bezüglich des Stators lagerbar ist, wobei der Rotor in einer zur axialen Richtung senkrechten radialen Ebene aktiv magnetisch gelagert ist, wobei der Stator eine Mehrzahl von Spulenkernen aufweist, von denen jeder einen Längsschenkel umfasst, welcher sich von einem ersten Ende in axialer Richtung bis zu einem zweiten Ende erstreckt, sowie einen Querschenkel, welcher an dem zweiten Ende des Längsschenkels und in der radialen Ebene angeordnet ist, und welcher sich von dem Längsschenkel in einer radialen Richtung erstreckt, wobei die Spulenkerne bezüglich einer Umfangsrichtung um die Ausnehmung herum angeordnet sind, und wobei an jedem Längsschenkel mindestens eine konzentrierte Wicklung vorgesehen ist, welche den jeweiligen Längsschenkel umgibt, und wobei die Kontrolleinheit für die Ansteuerung und die Versorgung der Wicklungen mit elektrischer Energie ausgestaltet ist. Bezüglich der axialen Richtung ist zwischen der Motoreinheit und der Kontrolleinheit ein thermisches Trennelement angeordnet, welches an der Motoreinheit und an der Kontrolleinheit anliegt, und welches einen direkten Wärmefluss aus der Motoreinheit in die Kontrolleinheit reduziert.

Das thermische Trennelement dient dazu, die Motoreinheit und die Kontrolleinheit thermisch voneinander zu entkoppeln. Hierdurch wird der Wärmeeintrag von der Motoreinheit in die Kontrolleinheit deutlich reduziert, sodass die elektronischen Komponenten in der Kontrolleinheit, wie beispielsweise die Leistungselektronik, sehr gut gegen die in der Motoreinheit generierte Wärme geschützt sind. Hierdurch lässt sich eine Überhitzung der Kontrolleinheit zuverlässig vermeiden.

Das thermische Trennelement stellt ein grosses Wärmereservoir dar, welches sowohl von der Motoreinheit als auch von der Kontrolleinheit Wärme aufnimmt und diese beispielsweise über die Oberfläche des Motorgehäuses an die Umgebung abgibt, sodass - wenn überhaupt - nur eine sehr geringe Wärmemenge von der Motoreinheit in die Kontrolleinheit fliesst oder umgekehrt, von der Kontrolleinheit in die Motoreinheit.

Durch das thermische Trennelement wird eine besonders kompakte Ausgestaltung des elektromagnetischen Drehantriebs ermöglicht, weil die Kontrolleinheit sehr nahe an der Motoreinheit angeordnet werden kann. Die Motoreinheit und die Kontrolleinheit sind nur durch das thermische Trennelement voneinander getrennt, welches einen direkten Wärmestrom von der Motoreinheit in die Kontrolleinheit - oder umgekehrt von der Kontrolleinheit in die Motoreinheit - zumindest deutlich reduziert.

Durch diese kompakte Ausgestaltung, bei welcher die Kontrolleinheit benachbart zu der Motoreinheit angeordnet ist, reduziert sich der Platzbedarf und die Komplexität für die Installation, weil keine separaten und räumlich voneinander weiter entfernte Räumlichkeiten für die Motoreinheit einerseits und die Kontrolleinheit andererseits zur Verfügung gestellt werden müssen. Auch reduziert sich der Aufwand für die Verbindung, beispielsweise die Verkabelung, zwischen der Motoreingeit und der Kontrolleinheit.

Zudem kann der Signalweg zwischen der Motoreinheit und der Kontrolleinheit, beispielsweise für Sensorsignale, erheblich verkürzt werden, wodurch die Störanfälligkeit des Signalwegs erheblich verkleinert wird.

Ferner sinken durch die kompakte Ausgestaltung auch die Gesamtkosten für die Herstellung und die Installation einer Vorrichtung, die einen erfindungsgemässen elektromagnetischen Drehantrieb aufweist.

Insbesondere bei leistungsstarken Drehantrieben, die beispielsweise eine Leistung von 2 Kilowatt (kW) oder mehr haben, ist es bevorzugt, dass in dem thermischen Trennelement eine Kühlleitung angeordnet ist, die von einem Kühlfluid durchströmbar ist. Durch diese Massnahme lässt sich die Wärmemenge, die pro Zeit aus dem thermischen Trennelement abgeführt wird, vergrössern.

In einer bevorzugten Ausgestaltung ist bezüglich der axialen Richtung zwischen den Wicklungen und den Querschenkeln eine Platine mit elektronischen Komponenten angeordnet ist. Die Platine ist beispielsweise als ein Elektronikprint bzw. ein PCB (Printed Circuit Board) ausgestaltet, der z. B. elektronische Komponenten für die Ansteuerung oder den Betrieb von Sensoren, beispielsweise Positionssensoren oder Magnetfeldsensoren, enthalten kann, oder Komponenten für die Auswertung der von Sensoren gelieferten Signale.

Es sind solche Ausgestaltungen möglich, bei welchen die Kontrolleinheit ein separates Kontrollgehäuse umfasst, welches bezüglich der axialen Richtung benachbart zum Motorgehäuse angeordnet ist, wobei das thermische Trennelement bezüglich der axialen Richtung zwischen dem Motorgehäuse und dem Kontrollgehäuse angeordnet ist. Das Kontrollgehäuse ist dann ein separates, von dem Motorgehäuse verschiedenes Gehäuse, in welchem die elektronischen Komponenten der Kontrolleinheit angeordnet sind.

Vorzugsweise sind das Motorgehäuse und das Kontrollgehäuse ohne direkten körperlichen Kontakt miteinander angeordnet. Das thermische Trennelement ist bezüglich der axialen Richtung derart zwischen der Motoreinheit und der Kontrolleinheit angeordnet, dass das Motorgehäuse und das Kontrollgehäuse keinen direkten körperlichen Kontakt miteinander haben. Auf der einen Seite liegt das Motorgehäuse an dem thermischen Trennelement an und auf der anderen Seite das Kontrollgehäuse, wobei sich das Motorgehäuse und das Kontrollgehäuse nicht berühren, sondern durch das dazwischen angeordnete Trennelement voneinander getrennt sind.

Gemäss einer bevorzugten Ausgestaltung umfasst der Stator ein thermisches Leitelement mit einer thermischen Leitplatte, welche bezüglich der axialen Richtung zwischen den Spulenkernen und dem thermischen Trennelement angeordnet ist, und welche in körperlichem Kontakt mit den Spulenkernen oder mit einem Rückschluss ist, mittels welchem die ersten Enden aller Längsschenkel zum Führen des magnetischen Flusses verbunden sind. Die thermische Leitplatte gewährleistet einen sehr guten thermischen Kontakt zwischen den Spulenkernen bzw. dem Rückschluss und dem thermischen Trennelement, sodass die im Betrieb generierte Wärme sehr effizient aus den Spulenkernen bzw. dem Rückschluss abgeführt wird. Die im Betrieb im Stator generierte Wärme ist insbesondere die von den konzentrierten Wicklungen generierte Wärme, also beispielsweise die Kupferverluste, sowie die durch Eisenverluste in den Spulenkernen oder dem Rückschluss erzeugte Wärme.

Eine weitere vorteilhafte Massnahme ist es, dass das thermische Leitelement eine Mehrzahl von mit der thermischen Leitplatte verbundenen Leitzähnen umfasst, wobei sich jeder Leitzahn jeweils in axialer Richtung erstreckt, und radial innenliegend bezüglich der Wicklungen in dem von den Wicklungen umgebenen Innenraum angeordnet ist. Dabei sind die Leitzähne bezüglich der radialen Richtung möglichst nahe an den Wicklungen angeordnet, sodass die Leitzähne die von den Wicklungen generierte Wärme und die in den Spulenkernen generierte Wärme möglichst gut aufnehmen und abführen können. Das thermische Leitelement, also insbesondere die thermische Leitplatte und die Leitzähne, sind aus einem gut wärmeleitenden Material, beispielsweise einem metallischen Werkstoff gefertigt. Ein bevorzugter Werkstoff für das thermische Leitelement ist Aluminium.

Ferner ist es bevorzugt, dass jeder Leitzahn bezüglich der radialen Richtung unmittelbar benachbart zu einem der Längsschenkel oder einer der Wicklungen angeordnet ist.

Beispielsweise ist die Anzahl der Leitzähne gleich der Anzahl der Spulenkerne. Vorzugsweise ist bezüglich der radialen Richtung benachbart zu jedem Spulenkern und der darauf angeordneten Wicklung genau ein Leitzahn angeordnet.

Eine weitere bevorzugte Massnahme besteht darin, dass in Umfangsrichtung gesehen zwischen zwei benachbarten Leitzähnen jeweils eine Aussparung vorgesehen ist, die sich bezüglich der axialen Richtung bis in den Bereich der ersten Enden der Längsschenkel erstreckt. Durch diese Aussparungen zwischen den Leitzähnen werden Wirbelstromverluste, welche aus den Streufeldern des Stroms in den Wicklungen resultieren, möglichst weit reduziert.

Gemäss einer weiteren bevorzugten Ausführungsform ist die Kontrolleinheit in dem Motorgehäuse angeordnet. Bei dieser Ausführungsform ist also kein separates Kontrollgehäuse vorgesehen, sondern die Kontrolleinheit ist ebenfalls im Motorgehäuse angeordnet.

Bei dieser Ausführungsform ist es eine bevorzugte Massnahme, dass das thermische Trennelement integraler Bestand des Motorgehäuses ist. Dazu ist das thermische Trennelement vorzugsweise einstückig mit dem Motorgehäuse ausgestaltet. Durch diese Massnahme lässt sich der thermische Widerstand stark reduzieren.

Ferner ist es bevorzugt, dass das Motorgehäuse einen Innenbecher umfasst, der im Wesentlichen zylindrisch ausgestaltet ist, und der radial innenliegend bezüglich der Wicklungen in dem von den Wicklungen umgebenen Innenraum angeordnet ist. Dieser Innenbecher kann die von den Wicklungen generierte Wärme, z.B. durch Kupferverluste verursachte Wärme, sowie die in den Spulenkernen und dem Rückschluss generierte Wärme, z.B. durch Eisenverluste generierte Wärme, sehr effizient aufnehmen und dann über die Aussenseite des Motorgehäuses an die Umgebung abgeben.

Vorzugsweise erstreckt sich der Innenbecher bezüglich der axialen Richtung über die gesamte Länge der Wicklungen.

Durch die Erfindung wird ferner eine Zentrifugalpumpe zum Fördern eines Fluids vorgeschlagen, welche einen elektromagnetischen Drehantrieb umfasst, der erfindungsgemäss ausgestaltet ist, sowie einen Rotor mit einem magnetisch wirksamen Kern, welcher in der Ausnehmung im Motorgehäuse angeordnet ist, wobei der Rotor als Rotor der Zentrifugalpumpe ausgestaltet ist wobei der Rotor des elektromagnetischen Drehantriebs als Rotor der Zentrifugalpumpe ausgestaltet ist.

Vorzugsweise umfasst die Zentrifugalpumpe ein Pumpengehäuse, das einen Pumpeneinlass und einen Pumpenauslass für das zu fördernde Fluid umfasst, wobei der Rotor im Pumpengehäuse angeordnet ist, und eine Mehrzahl von Flügeln zum Fördern des Fluids umfasst. Das Pumpengehäuse ist derart ausgestaltet, dass es so in die Ausnehmung im Motorgehäuse einsetzbar ist, dass der magnetisch wirksame Kern des Rotors von den Querschenkeln umgeben wird.

Weitere vorteilhafte Massnahmen und Ausgestaltungen der Erfindung ergeben sich aus den abhängigen Ansprüchen.

Im Folgenden wird die Erfindung anhand von Ausführungsbeispielen und anhand der Zeichnung näher erläutert. In der Zeichnung zeigen:
- Fig. 1:: eine perspektivische Explosionsdarstellung eines erstes Ausführungsbeispiels eines erfindungsgemässen elektromagnetischen Drehantriebs,
- Fig. 2:: eine perspektivische Darstellung des Stators des ersten Ausführungsbeispiels, teilweise im Schnitt, sowie den magnetisch wirksamen Kern eines Rotors,
- Fig. 3: eine perspektivische Darstellung des thermischen Leitelements des ersten Ausführungsbeispiels,
- Fig. 4:: eine schematische Schnittdarstellung der ersten Variante des ersten Ausführungsbeispiels in einem Schnitt in axialer Richtung,
- Fig. 5:: eine Schnittdarstellung des thermischen Trennelements der ersten Variante in einem Schnitt senkrecht zur axialen Richtung,
- Fig. 6: eine schematische Schnittdarstellung der zweiten Variante des ersten Ausführungsbeispiels in einem Schnitt in axialer Richtung,
- Fig. 7:: eine perspektivische Explosionsdarstellung eines zweiten Ausführungsbeispiels eines erfindungsgemässen elektromagnetischen Drehantriebs,
- Fig. 8:: eine schematische Schnittdarstellung des zweiten Ausführungsbeispiels in einem Schnitt in axialer Richtung,
- Fig. 9:: eine Schnittdarstellung des thermischen Trennelements des zweiten Ausführungsbeispiels in einem Schnitt senkrecht zur axialen Richtung,
- Fig. 10:: eine schematische Schnittdarstellung einer Variante des zweiten Ausführungsbeispiels in einem Schnitt in axialer Richtung,
- Fig. 11:: eine perspektivische Darstellung eines Ausführungsbeispiels einer erfindungsgemässen Zentrifugalpumpe, wobei die Pumpeneinheit getrennt vom Stator dargestellt ist, und
- Fig. 12:: eine schematische Schnittdarstellung des Ausführungsbeispiels aus Fig. 11 in einem Schnitt in axialer Richtung.

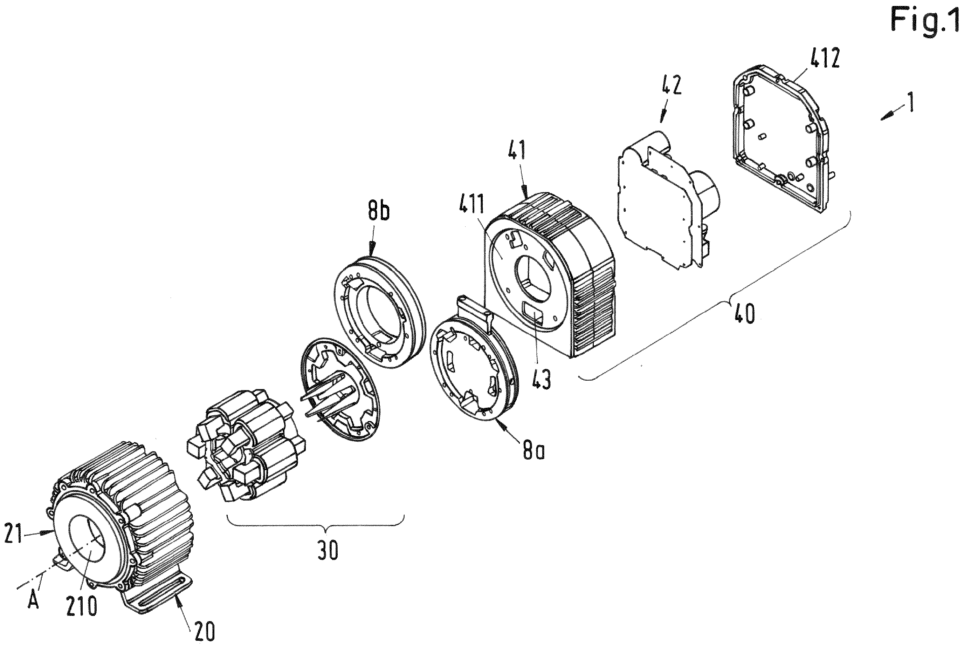

Fig. 1 zeigt eine perspektivische Explosionsdarstellung eines erstes Ausführungsbeispiels eines erfindungsgemässen elektromagnetischen Drehantriebs, der gesamthaft mit dem Bezugszeichen 1 bezeichnet ist. Der elektromagnetische Drehantrieb 1 umfasst eine Motoreinheit 30, die in einem Motorgehäuse 20 angeordnet ist, sowie eine Kontrolleinheit 40 für die Ansteuerung und für die Versorgung der Motoreinheit 30 mit elektrischer Energie. Bei dem ersten Ausführungsbeispiel umfasst die Kontrolleinheit 40 ein separates, das heisst von dem Motorgehäuse 20 verschiedenes Kontrollgehäuse 41, in welchem die verschiedenen elektronischen bzw. elektrischen Komponenten 42 der Kontrolleinheit 40 angeordnet sind. Zwischen dem Kontrollgehäuse 41 und dem Motorgehäuse 20 ist ein thermisches Trennelement 8a oder 8b vorgesehen, welches einerseits an der Motoreinheit 30 und dem Motorgehäuse 20 anliegt, und andererseits an der Kontrolleinheit 40. Das thermische Trennelement 8a, 8b reduziert oder verhindert einen direkten Wärmefluss aus der Motoreinheit 30 in die Kontrolleinheit 40 oder auch umgekehrt aus der Kontrolleinheit 40 in die Motoreinheit 30. Das thermische Trennelement 8a, 8b ist so ausgestaltet, dass das Motorgehäuse 20 und das Kontrollgehäuse 41 keinen direkten körperlichen Kontakt miteinander haben, sondern durch das thermische Trennelement 8a, 8b voneinander getrennt sind.

Das Motorgehäuse 20 und das Kontrollgehäuse 41 sind vorzugsweise aus einem metallischen Werkstoff gefertigt. Ein besonders geeigneter Werkstoff für das Motorgehäuse 20 und das Kontrollgehäuse 41 ist Aluminium, wobei insbesondere die nach aussen exponierten Seiten des Motorgehäuses 20 und des Kontrollgehäuses 41 mit einer Beschichtung ausgestaltet sein können, beispielsweise zur Verbesserung der chemischen Resistenz.

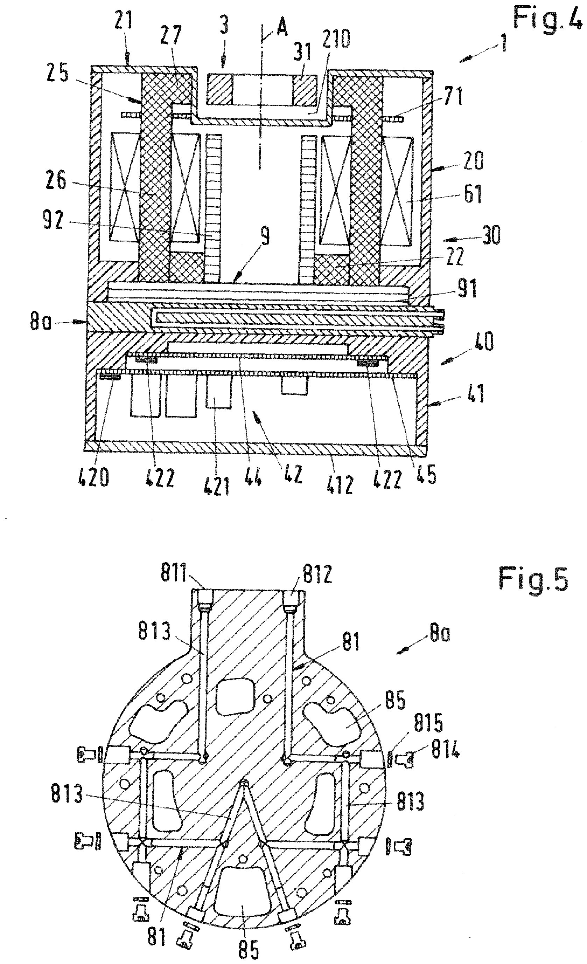

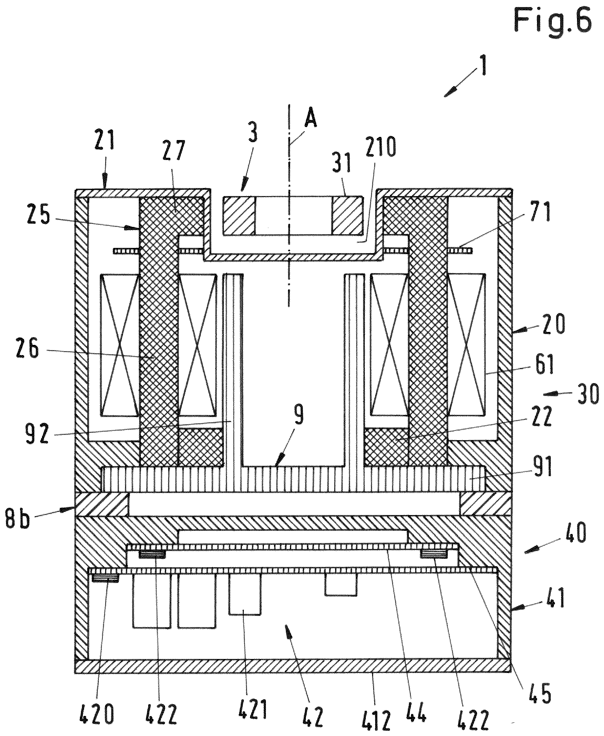

Für die Ausgestaltung des thermischen Trennelements 8a, 8b gibt es zwei Möglichkeiten, wie weiter hinten noch detaillierter erläutert wird. Gemäss einer ersten Variante des ersten Ausführungsbeispiels ist das thermische Trennelement 8a als ein aktives Kühlelement ausgestaltet, das von einem Kühlfluid durchströmbar ist. Fig. 4 zeigt in einer schematischen Schnittdarstellung diese erste Variante des ersten Ausführungsbeispiels mit dem thermischen Trennelement 8a. Gemäss einer zweiten Variante des ersten Ausführungsbeispiels ist das thermische Trennelement 8b als ein passives thermisches Trennelement 8b ausgestaltet, welches nicht von einem Kühlfluid durchströmt wird. Bei dieser Ausgestaltung als passives Trennelement 8b isoliert das Trennelement 8b die Motoreinheit 30 von der Kontrolleinheit 40 thermisch, so dass höchstens ein geringer Wärmefluss von der Kontrolleinheit 40 zur Motoreinheit 30 bzw. umgekehrt von der Motoreinheit 30 zu der Kontrolleinheit 40 vorhanden ist. Die im Betrieb generierte Wärme wird primär über Konvektion an die Umgebung abgegeben, beispielsweise über die Oberfläche des Motorgehäuses 20. Fig. 6 zeigt in einer schematischen Schnittdarstellung diese zweite Variante des ersten Ausführungsbeispiels mit dem thermischen Trennelement 8b.

Die Darstellung in Fig. 1 ist so zu verstehen, dass das thermische Trennelement 8a, 8b entweder als aktives thermisches Trennelement 8a (siehe Fig. 4) oder als passives thermisches Trennelement 8b (Fig. 6) ausgestaltet ist. Fig. 1 veranschaulicht somit die erste und die zweite Variante des ersten Ausführungsbeispiels.

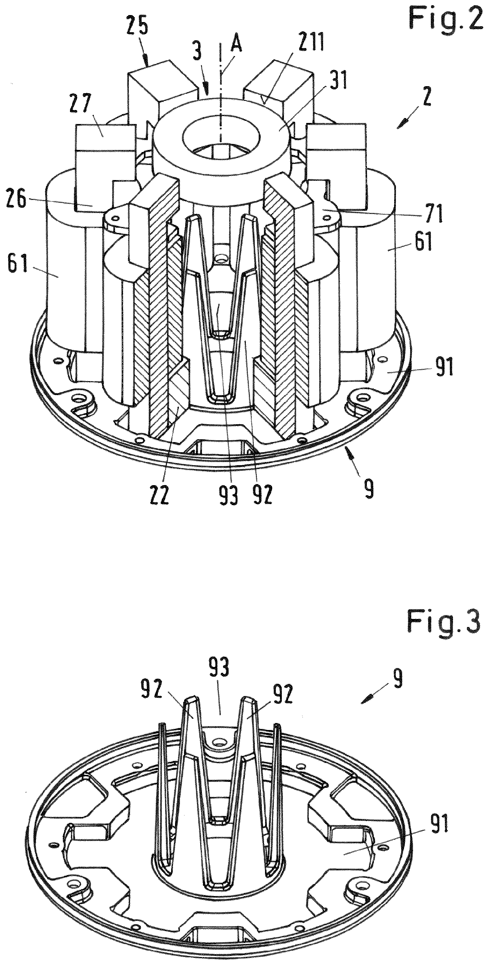

Das Motorgehäuse 20 weist in einer seiner Stirnflächen eine Ausnehmung 210 auf, welche zum Aufnehmen eines magnetisch wirksamen Kerns 31 (Fig. 2) eines Rotors 3 ausgestaltet ist.

Vorzugsweise ist die Ausnehmung 210 in einem separaten Rotorbecher 21 (siehe auch Fig. 4) vorgesehen, wobei der Rotorbecher 21 als Deckel des Motorgehäuses 20 ausgestaltet ist, welcher als axiale Stirnfläche das Motorgehäuses 20 an einem seiner axialen Enden verschliesst. Der Rotorbecher 21 ist fest mit dem Motorgehäuse 20 verbunden, beispielsweise verschraubt oder verklebt, oder durch eine Presspassung -mit oder ohne O-Ring- mit dem Motorgehäuse 20 verbunden. Der Rotorbecher 21 schliesst das Motorgehäuse 20 ab, vorzugsweise hermetisch dicht. Der separate Rotorbecher 21 ist vorzugsweise aus einem Kunststoff gefertigt, beispielsweise aus Polypropylen.

Der elektromagnetische Drehantrieb 1 ist als Tempelmotor ausgestaltet. Die Motoreinheit 30 umfasst einen Stator 2. Zum besseren Verständnis zeigt Fig. 2 noch eine perspektivische Darstellung des Stators 2, wobei in Fig. 2 das Motorgehäuse 20 nicht dargestellt ist und ein Segment aus dem Stator 2 herausgeschnitten ist.

Der Stator 2 weist eine Mehrzahl von Spulenkernen 25 auf - hier sechs Spulenkerne 25 -, von denen jeder gemäss der Ausgestaltung als Tempelmotor einen Längsschenkel 26 umfasst, welcher sich in einer axialen Richtung A erstreckt, sowie einen senkrecht zum Längsschenkel 26 angeordneten Querschenkel 27, welcher sich in einer radialen Richtung erstreckt, und durch eine Stirnfläche 211 begrenzt wird. Die Spulenkerne 25 sind äquidistant auf einer Kreislinie angeordnet, sodass die Stirnflächen 211 die Ausnehmung 210 umgeben, in welche der Rotor 3 mit dem magnetisch wirksamen Kern 31 einsetzbar ist. An jedem Längsschenkel 26 ist genau eine konzentrierte Wicklungen 61 vorgesehen, welche den jeweiligen Längsschenkel 26 umgibt.

In anderen Ausführungsformen können an jedem Längsschenkel 26 auch mehr als eine konzentrierte Wicklung 61, beispielsweise jeweils zwei konzentrierte Wicklungen vorgesehen sein, von denen jede den jeweiligen Längsschenkel 26 umgibt, und die bezüglich der axialen Richtung A benachbart zueinander angeordnet sind.

Die Längsschenkel 26 sind jeweils stabförmig oder im Wesentlichen stabförmig ausgestaltet. Insbesondere können die Längsschenkel 26 auch so ausgestaltet sein, wie es beispielsweise in der Fig. 3 oder in der Fig. 5 der EP 4 084 304 A1 dargestellt ist.

Der Rotor 3 ist bezüglich des Stators 2 berührungslos magnetisch lagerbar. Ferner ist der Rotor 3 mittels des Stators 2 berührungslos magnetisch zur Rotation um eine Solldrehachse antreibbar. Die Solldrehachse bezeichnet dabei diejenige Achse, um welche sich der Rotor 3 im Betriebszustand dreht, wenn sich der Rotor 3 bezüglich des Stators 2 in einer zentrierten und unverkippten Lage befindet, so wie dies in Fig. 2 für den magnetisch wirksamen Kern 31 des Rotors 3 dargestellt ist. Diese Solldrehachse definiert die axiale Richtung A. Üblicherweise stimmt die die axiale Richtung A festlegende Solldrehachse mit der Mittelachse des Stators 2 überein.

Im Folgenden wird mit einer radialen Richtung eine Richtung bezeichnet, welche senkrecht auf der axialen Richtung A steht.

Es versteht sich, dass die Anzahl von sechs Spulenkernen 25 nur beispielhaft zu verstehen ist. Es sind natürlich auch solche Ausgestaltungen möglich, bei denen der Stator 2 weniger als sechs, z. B. fünf Spulenkerne 25 aufweist, oder solche Ausgestaltungen, bei denen der Stator 2 mehr als sechs, z. B. sieben oder acht Spulenkerne 25 aufweist.

Der Rotor 3 umfasst den magnetisch wirksamen Kern 31, welcher ring- oder scheibenförmig ausgestaltet ist. Der magnetisch wirksame Kern 31 ist gemäss der Darstellung in Fig. 2 als Ring ausgestaltet und definiert eine magnetische Mittelebene. Alternativ kann der magnetisch wirksame Kern 31 auch als Scheibe ausgestaltet sein. In der Regel ist bei einem scheibenförmigen oder ringförmigen magnetisch wirksamen Kern 31 die magnetische Mittelebene die geometrische Mittelebene des magnetisch wirksamen Kerns 31 des Rotors 3, die senkrecht zur axialen Richtung A liegt. Im Betriebszustand ist der magnetisch wirksame Kern 31 in einer radialen Ebene gelagert, welche senkrecht auf der axialen Richtung A steht.

Die radiale Ebene ist diejenige Ebene, in welcher der magnetisch wirksame Kern 31 des Rotors 3 im Betriebszustand zwischen den Stirnflächen 211 im Stator 2 aktiv magnetisch gelagert ist. Wenn der Rotor 3 nicht verkippt und in axialer Richtung A nicht ausgelenkt ist, liegt die magnetische Mittelebene in der radialen Ebene. Die radiale Ebene definiert die x-y-Ebene eines kartesischen Koordinatensystems, dessen z-Achse in axialer Richtung A verläuft.

Mit der radialen Position des magnetisch wirksamen Kerns 31 bzw. des Rotors 3 wird die Lage des Rotors 3 in der radialen Ebene bezeichnet.

Da es für das Verständnis der Erfindung ausreichend ist, ist in der Zeichnung in den Fig. 2, 4, 6, 8 und 10 von dem Rotor 3 jeweils nur der magnetisch wirksame Kern 31 dargestellt. Es versteht sich, dass der Rotor 3 natürlich auch noch weitere Komponenten umfassen kann wie beispielsweise Ummantelungen oder Kapselungen, die vorzugsweise aus einem Kunststoff hergestellt sind, oder aus einem Metall oder aus einer Metalllegierung oder aus einer Keramik bzw. einem keramischen Werkstoff. Ferner kann der Rotor 3 auch Flügel zum Mischen, Rühren oder Pumpen von Fluiden oder sonstige Komponenten umfassen.

Der Stator 2 ist in dem Motorgehäuse 20 angeordnet (siehe Fig. 1), welches den Stator 2 vollständig umschliesst, sodass der gesamte Stator 2 im Inneren des Motorgehäuses 20 angeordnet ist. Zum besseren Verständnis ist in Fig. 2 das Motorgehäuse 20 nicht dargestellt, sodass die Komponenten des im Motorgehäuses 20 angeordneten Stators 2 erkennbar sind.

Besonders bevorzugt ist das Motorgehäuse 20 als ein hermetisch dichtes Motorgehäuse 20 ausgestaltet, welches den Stator 2 vollständig umkapselt. Das Motorgehäuse 20 ist vorzugsweise mit einer thermisch leitenden Vergussmasse, beispielsweise mit einem Epoxidharz oder mit einem Polyurethan, aufgefüllt, sodass der Stator 2 und gegebenenfalls weitere Komponenten, die im Inneren des Motorgehäuses 20 angeordnet sind, mit der Vergussmasse umgeben sind. Dadurch wird der allgemeine thermische Widerstand reduziert und Vibrationen werden gedämpft.

Wenn der Rotor 3 in die Ausnehmung 210 im Motorgehäuse 20 eingesetzt ist, sind der Rotor 3 und insbesondere der magnetisch wirksame Kern 31 des Rotors 3 von den radial aussenliegend angeordneten Querschenkeln 27 der Spulenkerne 25 des Stators 2 umgeben. Die Querschenkel 27 bilden somit eine Mehrzahl von ausgeprägten Statorpolen- hier sechs Statorpole. Die Längsschenkel 26 der Spulenkerne 25 erstrecken sich jeweils von einem ersten Ende, welches das darstellungsgemäss (Fig. 2) untere Ende ist, in axialer Richtung A bis zu einem zweiten Ende, welches das darstellungsgemäss obere Ende ist. Die Querschenkel 27 sind an den oberen Enden der Längsschenkel 26 und in der radialen Ebene angeordnet. Jeder Querschenkel 27 erstreckt sich in der radialen Richtung auf den Rotor 3 zu.

Wenn sich der magnetisch wirksame Kern 31 des Rotors 3 während des Betriebs in seiner Soll-Position befindet, so ist der magnetisch wirksame Kern 31 zwischen den Stirnflächen 211 der Querschenkel 27 zentriert, sodass die in der radialen Ebene angeordneten Querschenkel 27 auch in der magnetischen Mittelebene liegen. Die konzentrierten Wicklungen 61 sind darstellungsgemäss unterhalb der radialen Ebene angeordnet und so ausgerichtet, dass ihre Spulenachsen jeweils in axialer Richtung A verlaufen.

Alle ersten Enden der Längsschenkel 26 - also die darstellungsgemäss unteren Enden - sind durch einen Rückschluss 22 miteinander verbunden. Der Rückschluss 22 ist vorzugsweise ringförmig ausgestaltet. Dabei sind solche Ausgestaltungen möglich, bei welchen sich der Rückschluss 22 radial innenliegend entlang aller ersten Enden der Längsschenkel 26 erstreckt. Es ist aber auch möglich, dass der Rückschluss 22 entlang seines Umfangs mehrere Ausnehmungen aufweist, von denen jede eines der ersten Enden aufnimmt. In anderen Ausführungsformen kann der Rückschluss 22 auch eine Mehrzahl von Ringsegmenten umfassen, von denen jedes jeweils zwischen zwei in Umfangsrichtung benachbarten Spulenkernen 25 im Bereich der ersten Enden angeordnet ist.

Um die für den magnetischen Antrieb und die magnetische Lagerung des Rotors 3 notwendigen elektromagnetischen Drehfelder zu erzeugen, tragen die Längsschenkel 26 der Spulenkerne 25 die als konzentrierte Wicklungen 61 ausgestalteten Wicklungen 61, wobei bei dem ersten Ausführungsbeispiel um jeden Längsschenkel 26 herum genau eine konzentrierte Wicklung 61 angeordnet ist. Mit diesen konzentrierten Wicklungen 61 werden im Betriebszustand diejenigen elektromagnetischen Drehfelder erzeugt, mit welchen ein Drehmoment auf den Rotor 3 bewirkt wird, und mit welchen eine beliebig einstellbare Querkraft in radialer Richtung auf den Rotor 3 ausübbar ist, sodass die radiale Position des Rotors 3, also seine Position in der zur axialen Richtung A senkrechten radialen Ebene, aktiv steuerbar bzw. regelbar ist.

Mit dem "magnetisch wirksamen Kern 31" des Rotors 3 ist derjenige Bereich des Rotors 3 gemeint, welcher für die Drehmomentbildung sowie für die Erzeugung der magnetischen Lagerkräfte magnetisch mit dem Stator 2 zusammenwirkt.

Wie bereits erwähnt, ist der magnetisch wirksame Kern 31 bei diesem Ausführungsbeispiel ringförmig ausgestaltet. Ferner ist der magnetisch wirksame Kern 31 permanentmagnetisch ausgestaltet. Dazu kann der magnetisch wirksame Kern 31 mindestens einen Permanentmagneten, aber auch mehrere Permanentmagnete umfassen oder - wie im hier beschriebenen ersten Ausführungsbeispiel - vollständig aus einem permanentmagnetischen Material bestehen, sodass der magnetisch wirksame Kern 31 der Permanentmagnet ist. Der magnetisch wirksame Kern 31 ist beispielsweise in radialer Richtung magnetisiert.

Als Permanentmagnete bezeichnet man üblicherweise solche ferromagnetischen oder ferrimagnetischen Werkstoffe, die hartmagnetisch sind, also eine hohe Koerzitivfeldstärke aufweisen. Die Koerzitivfeldstärke ist diejenige magnetische Feldstärke, die man benötigt, um einen Stoff zu entmagnetisieren. Im Rahmen dieser Anmeldung wird unter einem Permanentmagneten ein Werkstoff bzw. ein Material verstanden, der eine Koerzitivfeldstärke, genauer gesagt eine Koerzitivfeldstärke der magnetischen Polarisation aufweist, die mehr als 10'000 A/m beträgt.

Es sind auch solche Ausgestaltungen möglich, bei denen der magnetisch wirksame Kern 31 permanentmagnetfrei, also ohne Permanentmagnete ausgestaltet ist. Der Rotor 3 ist dann z.B. als Reluktanzläufer ausgestaltet. Der magnetisch wirksame Kern 31 des Rotors 3 besteht dann beispielsweise aus einem weichmagnetischen Material. Geeignete weichmagnetische Materialien für den magnetisch wirksamen Kern 31 sind beispielsweise ferromagnetische oder ferrimagnetische Materialien, also insbesondere Eisen, Nickel-Eisen, Kobalt-Eisen, Silizium-Eisen, Mu-Metall.

Ferner sind Ausgestaltungen möglich, bei denen der magnetisch wirksame Kern 31 des Rotors 3 sowohl ferromagnetische Materialien als auch permanentmagnetische Materialien umfasst. Beispielsweise können Permanentmagnete in einen ferromagnetischen Grundkörper eingelegt bzw. eingesetzt werden. Solche Ausgestaltungen sind z.B. vorteilhaft, wenn man bei grossen Rotoren die Kosten durch Einsparen von permanentmagnetischem Material reduzieren will.

Auch sind Ausgestaltungen möglich, bei denen der Rotor 3 nach dem Prinzip eines Käfigläufers ausgestaltet ist.

Sowohl der ringförmige Rückschluss 22 als auch die Spulenkerne 25 des Stators 2 sind jeweils aus einem weichmagnetischen Material gefertigt, weil sie als Flussleitelemente zur Führung des magnetischen Flusses dienen.

Geeignete weichmagnetische Materialien für die Spulenkerne 25 und den Rückschluss 22 sind beispielsweise ferromagnetische oder ferrimagnetische Materialien, also insbesondere Eisen, Nickel-Eisen, Kobalt-Eisen Silizium-Eisen oder Mu-Metall. Hierbei ist für den Stator 2 eine Ausgestaltung als Statorblechpaket bevorzugt, bei welcher die Spulenkerne 25 und der Rückschluss 22, geblecht ausgestaltet sind, das heisst sie bestehen aus mehreren dünnen Blechelementen, die gestapelt sind.

Ferner ist es möglich, dass die Spulenkerne 25 und der Rückschluss 22 aus gepressten und anschliessend gesinterten Körnern der genannten Materialien bestehen. Die metallischen Körner sind dabei vorzugsweise in eine Kunststoffmatrix eingebettet, sodass sie zumindest teilweise gegeneinander elektrisch isoliert sind, wodurch sich Wirbelstromverluste minimieren lassen. Es sind also für den Stator auch weichmagnetische Verbundwerkstoffe geeignet, welche aus elektrisch isolierten und zusammengepressten Metallpartikeln bestehen. Insbesondere können diese weichmagnetischen Verbundwerkstoffe, die auch als SMC (Soft Magnetic Composites) bezeichnet werden, aus Eisenpulverpartikeln bestehen, die mit einer elektrisch isolierenden Schicht beschichtet sind. Diese SMC werden dann mittels pulvermetallurgischer Verfahren zu der gewünschten Ausgestaltung geformt.

Während des Betriebs des elektromagnetischen Drehantriebs 1 wirkt der magnetisch wirksame Kern 31 des Rotors 3 mit dem Stator 2 nach dem eingangs beschriebenen Prinzip des lagerlosen Motors zusammen, bei welchem der Rotor 3 berührungslos magnetisch antreibbar und berührungslos magnetisch bezüglich des Stators 2 lagerbar ist. Dazu ist der Stator 2 als Lager- und Antriebsstator ausgestaltet, mit welchem der Rotor 3 im Betriebszustand berührungslos magnetisch um die Solldrehachse antreibbar - also in Rotation versetzbar- und bezüglich des Stators 2 berührungslos magnetisch lagerbar ist. Dabei sind drei Freiheitsgrade des Rotors 3, nämlich seine Position in der radialen Ebene und seine Rotation, aktiv regelbar. Bezüglich seiner axialen Auslenkung aus der radialen Ebene in axialer Richtung A ist der magnetisch wirksame Kern 31 des Rotors 3 passiv magnetisch, das heisst nicht ansteuerbar, durch Reluktanzkräfte stabilisiert. Auch bezüglich der verbleibenden zwei Freiheitsgrade, nämlich Verkippungen bezüglich der zur Solldrehachse senkrechten radialen Ebene ist der magnetisch wirksame Kern 31 des Rotors 3 ebenfalls passiv magnetisch stabilisiert. Der Rotor 3 ist also durch das Zusammenwirken des magnetisch wirksamen Kerns 31 mit den Spulenkernen 25 in axialer Richtung A sowie gegen Verkippungen (insgesamt drei Freiheitsgrade) passiv magnetisch gelagert oder passiv magnetisch stabilisiert und in der radialen Ebene (zwei Freiheitsgrade) aktiv magnetisch gelagert.

Wie dies allgemein üblich ist, bezeichnet auch im Rahmen dieser Anmeldung eine aktive magnetische Lagerung eine solche, die aktiv steuer- bzw. regelbar ist, beispielsweise über die mit den konzentrierten Wicklungen 61 generierten elektromagnetischen Drehfelder. Eine passive magnetische Lagerung oder eine passive magnetische Stabilisierung bezeichnet eine solche, die nicht ansteuerbar bzw. regelbar ist. Die passive magnetische Lagerung oder Stabilisierung basiert beispielsweise auf Reluktanzkräften, welche den Rotor 3 bei einer Auslenkung aus seiner Soll-Position, also z. B. bei einer Verschiebung oder Auslenkung in axialer Richtung A oder bei einer Verkippung, wieder in seine Soll-Position bringen.

Mit einer Radiallagerung oder einer radialen Lagerung wird eine Lagerung des Rotors 3 bezeichnet, mit welcher die radiale Position des Rotors 3 stabilisiert werden kann, also eine Lagerung, welche den Rotor 3 in der radialen Ebene und damit bezüglich seiner radialen Position lagert.

Mit einer Axiallagerung oder einer axialen Lagerung bzw. mit einer Axialstabilisierung oder einer axialen Stabilisierung wird eine Lagerung bzw. eine Stabilisierung des Rotors 3 bezeichnet, mit welcher zum einen die Position des Rotors 3 bezüglich der axialen Richtung A stabilisiert wird, und mit welcher zum anderen der Rotor 3 gegen Verkippungen stabilisiert ist. Solche Verkippungen stellen zwei Freiheitsgrade dar und bezeichnen Auslenkungen, bei denen die momentane Drehachse des Rotors 3 nicht mehr genau in die axiale Richtung A zeigt, sondern einen von Null verschiedenen Winkel mit der Solldrehachse einschliesst. Bei einer Verkippung liegt also die magnetische Mittelebene nicht mehr in oder parallel zur radialen Ebene, sondern die magnetische Mittelebene schliesst einen von Null verschiedenen Winkel mit der radialen Ebene ein.

Beim lagerlosen Motor werden im Unterschied zu klassischen Magnetlagern die magnetische Lagerung und der Antrieb des Motors über elektromagnetische Drehfelder realisiert. Typischerweise wird in dem lagerlosen Motor die magnetische Antriebs- und Lagerfunktion durch die Überlagerung zweier magnetischer Drehfelder generiert, die üblicherweise als Antriebs- und Steuerfeld bezeichnet werden. Diese beiden mit den Wicklungen des Stators erzeugten Drehfelder haben in der Regel eine Polpaarzahl, die sich um eins unterscheidet. Hat also beispielsweise das Antriebsfeld die Polpaarzahl p, so hat das Steuerfeld die Polpaarzahl p+1 oder p-1. Dabei werden mit dem Antriebsfeld auf den magnetisch wirksamen Kern 31 in der radialen Ebene wirkende Tangentialkräfte erzeugt, die ein Drehmoment bewirken, was die Rotation um die axiale Richtung A bewirkt. Durch die Überlagerung des Antriebsfelds und des Steuerfelds lässt sich zusätzlich eine beliebig einstellbare Querkraft auf den magnetisch wirksame Kern 31 in der radialen Ebene erzeugen, mit welcher die Position des magnetisch wirksamen Kerns 31 in der radialen Ebene regelbar ist. Es ist also nicht möglich, den elektromagnetischen Fluss, der von den konzentrierten Wicklungen 61 generiert wird, aufzuteilen in einen (elektro-) magnetischen Fluss, der nur für den Antrieb der Rotation sorgt und einen (elektro-) magnetischen Fluss, der nur die magnetische Lagerung realisiert.

Zur Generierung des Antriebs- und des Steuerfelds ist es einerseits möglich, zwei unterschiedliche Wicklungssysteme zu verwenden, nämlich eines zur Erzeugung des Antriebsfelds und eines zur Erzeugung des Steuerfelds. Die Spulen zur Erzeugung des Antriebsfelds werden dann üblicherweise als Antriebsspulen bezeichnet und die Spulen zur Erzeugung des Steuerfelds als Steuerspulen.

So können beispielsweise auf jedem Spulenkern 25 jeweils zwei konzentrierte Wicklungen vorgesehen sein, die bezüglich der axialen Richtung A benachbart zueinander angeordnet sind. Eine der Wicklungen wird als Antriebsspule eingesetzt, während die andere, zu ihr benachbarte konzentrierte Wicklung als Steuerspule eingesetzt wird. Der Strom, der in diese Spulen eingeprägt wird, wird dann als Antriebsstrom bzw. als Steuerstrom bezeichnet. Mit der Gesamtheit aller Antriebsspulen wird dann das Antriebsfeld generiert, welches ein elektromagnetisches Drehfeld ist, während mit der Gesamtheit der Steuerspulen das Steuerfeld generiert wird, welches ebenfalls ein elektromagnetisches Drehfeld ist, und welches dem Antriebsfeld überlagert wird. Durch die Überlagerung des Antriebsfelds und des Steuerfelds lassen sich dann die Tangentialkräfte auf den Rotor 3 generieren, welche das Drehmoment zum Antreiben der Rotation erzeugen, sowie eine beliebig einstellbare Querkraft in der radialen Ebene, mit welcher die Position des magnetisch wirksamen Kerns 31 in der radialen Ebene aktiv regelbar ist.

Es sind aber auch solche Ausgestaltungen möglich, bei denen die Antriebs- und Lagerfunktion mit nur einem einzigen Wicklungssystem generiert wird, sodass es also keine Unterscheidung zwischen Antriebs- und Steuerspulen gibt. Eine solche Ausgestaltung ist bei dem ersten Ausführungsbeispiel vorgesehen. Wie dies Fig. 2 zeigt, ist an jedem Spulenkern 25 jeweils genau eine konzentrierte Wicklung 61 vorgesehen, wobei mit der Gesamtheit der konzentrierten Wicklungen 61 sowohl das Antriebsfeld als auch das Steuerfeld generiert werden. Dies kann so realisiert werden, dass die von der Kontrolleinheit 40 jeweils ermittelten Werte für den Antriebs- und den Steuerstrom rechnerisch -also z. B. mit Hilfe von Software - addiert bzw. überlagert werden und der sich daraus ergebende Gesamtstrom in die jeweilige konzentrierte Wicklung 61 eingeprägt wird. In diesem Fall ist es natürlich nicht mehr möglich, zwischen Steuer- und Antriebsspulen zu unterscheiden. Es gibt dann nur ein Wicklungssystem, in dessen konzentrierten Wicklungen 61 die rechnerisch ermittelte Summe aus dem Antriebs- und dem Steuerstrom eingeprägt wird.

Bei dem ersten Ausführungsbeispiel ist ferner eine Platine 71 (Fig. 2) mit nicht näher dargestellten elektronischen Komponenten vorgesehen. Die Platine 71 ist vorzugsweise als Elektronikprint bzw. PCB (printed circuit board) ausgestaltet. Auf der Platine 71 können beispielsweise solche Komponenten vorgesehen sein, die für die Ansteuerung von Sensoren (nicht dargestellt) und/oder für die Auswertung der von Sensoren ermittelten Messsignale verwendet werden. Solche Sensoren umfassen beispielsweise Positionssensoren zur Bestimmung der aktuellen Position des Rotors 3. Die Platine 71 bzw. die darauf vorgesehenen elektronischen Komponenten sind mit der Kontrolleinheit 40 signalverbunden.

Die Platine 71 ist im Wesentlichen ringförmig ausgestaltet und parallel zur radialen Ebene angeordnet. Vorzugsweise ist die ringförmige Platine 71 radial innenliegend bezüglich der Spulenkerne 25 angeordnet, wobei sich die Platine 71 - wie in Fig. 2 zu erkennen ist - auch in die Zwischenräume zwischen den Längsschenkeln 26 benachbarter Spulenkerne 25 hinein erstrecken kann.

Bezüglich der axialen Richtung A ist die Platine 71 zwischen den Wicklungen 61 und den Querschenkeln 27 der Spulenkerne 25 angeordnet. Gemäss der Darstellung in Fig. 2 ist die Platine 71 also unterhalb und benachbart zu den Querschenkeln 27 angeordnet, welche um den magnetisch wirksamen Kern 31 des Rotors 3 herum angeordnet sind.

Die Kontrolleinheit 40 umfasst die elektrischen oder elektronischen Komponenten 42, welche für die Ansteuerung und die Versorgung der Wicklungen 61 mit elektrischer Energie notwendig sind. Dies sind insbesondere Gleichrichter oder Umrichter, mit denen die Spannung bzw. der Strom zur Versorgung der Wicklungen 61 bereitgestellt werden, Leistungsschalter 420 (Fig. 4) für die Gleichrichter, Filterkomponenten 421, z.B. Kondensatoren oder Induktivitäten für die Glättung des Gleichstroms, Leistungsschalter 422 für die Ansteuerung der Wicklungen 61, mit denen der den Wicklungen 61 zugeführte Strom geschaltet wird, Regel- und Steuerkomponenten für die Kontrolle der berührungslosen magnetischen Lagerung und des berührungslosen magnetischen Antriebs, Auswertekomponenten für Sensorsignale. Der Gleichrichter für die Bereitstellung der Versorgungsspannung für die Wicklungen 61 ist vorzugsweise mit einem Leistungsfaktorkorrekturfilter (PFC: Power Faktor Correction oder Power Factor Compensation) ausgestaltet, um die Verzerrungsblindleistung zu reduzieren und somit den Leistungsfaktor des Gleichrichters zu erhöhen.

Bei dem ersten Ausführungsbeispiel des erfindungsgemässen Drehantriebs, umfasst der Stator 2 ferner ein thermisches Leitelement 9 zum Abführen der Wärme, die während des Betriebs in den Wicklungen 61, den Spulenkernen 25 und dem Rückschluss 22 generiert wird. Diese Wärme basiert insbesondere auf den Kupferverlusten in den Wicklungen 61 sowie den Eisenverlusten in den Spulenkernen 25 und dem Rückschluss 22. Das thermische Leitelement 9 dient dazu, die in den Wicklungen 61, den Spulenkernen 25 und dem Rückschluss 22 generierte Wärme möglichst gut abzuleiten. Zum besseren Verständnis zeigt Fig. 3 noch eine perspektivische Darstellung des thermischen Leitelements 9.

Bei dem ersten Ausführungsbeispiel umfasst das thermische Leitelement 9 eine thermische Leitplatte 91, welche bezüglich der axialen Richtung A zwischen den Spulenkernen 25 und dem thermischen Trennelement 8a, 8b angeordnet ist. Die thermische Leitplatte 91 ist in sehr gutem Wärmekontakt, vorzugsweise in körperlichen Kontakt, einerseits mit dem thermischen Trennelement 8a, 8b und andererseits mit den Spulenkernen 25 oder mit dem Rückschluss 22. Vorzugsweise ist die thermische Leitplatte 91 mit den ersten -darstellungsgemäss unteren- Enden aller Spulenkerne 25 in körperlichem Kontakt und mit dem Rückschluss 22. Besonders bevorzugt liegt die thermische Leitplatte 91 über den gesamten Umfang an dem Rückschluss 22 an, um von diesem möglichst gut Wärme aufnehmen zu können. Um den Wärmekontakt zwischen den Spulenkernen 25 bzw. dem Rückschluss 22 und der thermischen Leitplatte 91 noch zu verbessern, ist es möglich, eine Wärmeleitpaste, beispielsweise eine Thermopaste, zwischen der thermischen Leitplatte 91 und den Spulenkernen 25 bzw. dem Rückschluss 22 vorzusehen, welche die aneinandergrenzenden Komponenten besonders gut thermisch miteinander koppelt.

Das thermische Leitelement 9 umfasst ferner eine Mehrzahl - hier sechs -Leitzähnen 92, von denen jeder mit der thermischen Leitplatte 91 verbunden ist. Jeder Leitzahn 92 erstreckt sich jeweils von der thermischen Leitplatte 91 in axialer Richtung A und ist radial innenliegend bezüglich der Wicklungen 61 in dem von den Wicklungen 61 umgegebenen Innenraum angeordnet, wie das insbesondere in Fig. 2 zu erkennen ist. Vorzugsweise ist die Anzahl der Leitzähne 92 gleich der Anzahl der Spulenkerne 25 und vor jedem Spulenkern 25 ist genau ein Leitzahn 92 angeordnet. Bezüglich der radialen Richtung sind die Leitzähne 92 möglichst nahe an den Längsschenkeln 26 der Spulenkerne 25 bzw. den darauf angeordneten Wicklungen 61 angeordnet, sodass die Leitzähne 92 die von den Wicklungen 61 und den Spulenkernen 25 generierte Wärme besonders gut aufnehmen und abführen können.

Ferner ist es bevorzugt, dass das thermische Leitelement 9 einstückig ausgestaltet ist, um thermische Widerstände in dem thermischen Leitelement 9 zu minimieren. Das thermische Leitelement besteht aus einem gut wärmeleitenden Material, beispielsweise aus einem metallischen Werkstoff. Ein bevorzugter Werkstoff für das thermische Leitelement 9 ist Aluminium.

Eine weitere bevorzugte Massnahme besteht darin, dass in Umfangsrichtung gesehen zwischen zwei benachbarten Leitzähnen 9 jeweils eine Aussparung 93 vorgesehen ist, die sich bezüglich der axialen Richtung A bis in den Bereich der ersten Enden der Längsschenkel 26 oder bis an die thermische Leitplatte 91 erstreckt. Durch diese Aussparungen 93 werden Wirbelströme bzw. Wirbelstromverluste minimiert. Solche Wirbelströme könnten durch die Streufelder des in den Wicklungen 61 fliessenden Stroms in dem thermischen Leitelement 9 induziert werden. Die Aussparungen 93 führen zu einer deutlichen Reduktion von Wirbelstromverlusten im thermischen Leitelement 9.

Die Anordnung der Leitzähne 92 und der dazwischen liegenden Aussparungen 93 bezüglich der Umfangsrichtung ist derart, dass jeder Leitzahn 92 genau einem Längsschenkel 26 gegenüberliegt, und jede Aussparung 93 zwischen zwei benachbarten Spulenkernen 25 angeordnet ist.

Im Folgenden wird bezugnehmend auf Fig. 4 die erste Variante des ersten Ausführungsbeispiels näher erläutert, also diejenige Variante, bei welcher das thermische Trennelement 8a als ein aktives Kühlelement ausgestaltet ist. Fig. 4 zeigt diese erste Variante des ersten Ausführungsbeispiels in einer schematischen Schnittdarstellung in einem Schnitt in axialer Richtung A.

Wie dies in Fig. 4 gut zu erkennen ist, haben das Motorgehäuse 20 und das davon verschiedene Kontrollgehäuse 41 der Kontrolleinheit 40 keinen direkten körperlichen Kontakt miteinander, sondern sind durch das thermische Trennelement 8a voneinander getrennt, welches bezüglich der axialen Richtung A zwischen dem Motorgehäuse 20 und dem Kontrollgehäuse 41 angeordnet ist. Auf der einen Seite liegt das thermische Trennelement 8a an dem Motorgehäuse 20 an, ist also in körperlichem Kontakt mit dem Motorgehäuse 20. Auf der anderen Seite liegt das thermische Trennelement 8a an dem Kontrollgehäuse 41 an, ist also in körperlichem Kontakt mit dem Kontrollgehäuse 41.

Zum besseren Verständnis zeigt Fig. 5 eine Schnittdarstellung des thermischen Trennelements 8a der ersten Variante in einem Schnitt senkrecht zur axialen Richtung A. Das thermische Trennelement 8a ist plattenförmig ausgestaltet und hat im Wesentlichen die Form einer Kreisscheibe. In dem thermischen Trennelement 8a ist mindestens ein Durchlass 85 vorgesehen, welcher sich in axialer Richtung vollständig durch das thermische Trennelement 8a hindurch erstreckt. Vorzugsweise sind - wie in Fig. 4 dargestellt - mehrere solcher Durchlässe 85 vorgesehen. Die Durchlässe 85 dienen dazu, dass Signalverbindungen aus der Kontrolleinheit 40 durch das thermische Trennelement 8a hindurch in die Motoreinheit 30 geführt werden können, beispielsweise elektrische Leitungen zum Versorgen der Wicklungen 61 mit elektrischer Energie.

Das Trennelement 8a ist vorzugsweise aus einem metallischen Werkstoff gefertigt, beispielsweise aus einem Stahl oder aus einem Edelstahl. Ferner können die Aussenflächen des thermischen Trennelements 8a, also diejenigen Flächen, die mit der Umgebung in Kontakt sind, mit einer Beschichtung (nicht dargestellt) versehen sein.

Wie dies insbesondere Fig. 4 zeigt, liegen sowohl die thermische Leitplatte 91 des thermischen Leitelements 9 als auch das Motorgehäuse 20 an dem thermischen Trennelement 8a an, um eine möglichst gute thermische Anbindung des thermischen Trennelements 8a an den Rückschluss 22, die Wicklungen 61, die Spulenkerne 25 und das Motorgehäuse 20 zu gewährleisten. Hierdurch wird es ermöglicht, dass die im Betrieb im Stator 2 generierte Wärme, die vor allem auf den Eisenverlusten und den Kupferverlusten beruht, effizient und zuverlässig in das thermische Trennelement 8a abgeführt wird.

Auf der der Motoreinheit 30 abgewandten Seite liegt das thermische Trennelement 8a an dem Kontrollgehäuse 41 der Kontrolleinheit 40 an, um einen sehr guten Wärmekontakt zwischen der Kontrolleinheit 40 und dem thermischen Trennelement 8a zu gewährleisten. Das Kontrollgehäuse 41 weist mehrere Öffnungen 43 auf (siehe Fig. 1), durch welche Signalverbindungen (nicht dargestellt) aus der Kontrolleinheit 40 hinaus durch die Durchlässe 85 des thermischen Trennelements 8a hindurch in die Motoreinheit 30 geführt werden können, beispielsweise elektrische Leitungen zum Versorgen der Wicklungen 61 mit elektrischer Energie.

Das Kontrollgehäuse 41 umfasst ferner einen Kontrollgehäusedeckel 412, welcher das Kontrollgehäuse 41 an seiner dem thermischen Trennelement 8a abgewandten axialen Stirnseite verschliesst, vorzugsweise hermetisch verschliesst. Der Kontrollgehäusedeckel 412 ist vorzugsweise aus einem metallischen Werkstoff, beispielsweise Aluminium, gefertigt. Der Kontrollgehäusedeckel 412 ist mit einer oder mehreren Durchführung(en) ausgestaltet (nicht dargestellt), durch welche ein Versorgungskabel zum Einspeisen elektrischer Energie oder ein Schnittstellenkabel zur Ansteuerung des elektromagnetischen Drehantriebs 1 und/oder zum Datenaustausch von aussen in das Kotrollgehäuse 41 hineingeführt werden können.

Die Kontrolleinheit 40 umfasst mindestens eine, vorzugsweise mehrere Platinen 44, 45, auf welchen die elektronischen Komponenten 42 der Kontrolleinheit 40 angeordnet sind. Jede Platine 44, 45 ist vorzugsweise als Elektronikprint bzw. PCB (printed circuit board) ausgestaltet. Bei dem hier beschriebenen Ausführungsbeispiel umfasst die Kontrolleinheit 40 eine Kontrollerplatine 44 und eine Versorgungsplatine 45, die parallel zueinander und bezüglich der axialen Richtung A versetzt zueinander angeordnet sind.

Die Versorgungsplatine 45 umfasst alle die elektronischen Komponenten 42, die für die Bereitstellung einer Gleichspannung sorgen, mit welchen insbesondere die Wicklungen 61 mit elektrischer Energie versorgt werden können. Da der elektromagnetische Drehantrieb 1 typischerweise an eine externe Wechselstromquelle (nicht dargestellt) angeschlossen wird, beispielsweise an eine technische Drehstromquelle mit drei Phasen oder an eine übliche einphasige Wechselstromquelle mit einer Wechselspannung von 200-240 Volt, ist auf der Versorgungsplatine 45 ein Gleichrichter oder Umrichter vorgesehen, welcher die Wechselspannung in eine Gleichspannung umwandelt, die dann beispielsweise als Zwischenkreisspannung für die Ansteuerung der Wicklungen 61 verwendet wird. Der Umrichter umfasst Leistungsschalter 420 für die Gleichrichtung sowie die PFC Schaltung. Ferner sind auf der Versorgungsplatine 45 Filterkomponenten 421 vorgesehen, z.B. Kondensatoren oder Induktivitäten für die Glättung des Gleichstroms.

Auf der Kontrollerplatine 44 sind diejenigen elektronischen Komponenten vorgesehen, welche für die Ansteuerung der Wicklungen 61 zum Realisieren der Antriebs- und der Lagerfunktion benötigt werden. Dies sind insbesondere die Leistungsschalter 422 für die Ansteuerung der Wicklungen 61. Die für die Leistungsschalter 422 benötigte Zwischenkreisspannung wird von der Versorgungsplatine 45 zur Verfügung gestellt. Auf der Kontrollerplatine 44 sind ferner Regel- und Steuerkomponenten für die Kontrolle der berührungslosen magnetischen Lagerung und des berührungslosen magnetischen Antriebs vorgesehen sowie optional Auswertekomponenten für Sensorsignale (nicht dargestellt).

Um die Schaltverluste möglichst gering zu halten, sind die Leistungsschalter 420, 422 vorzugsweise aus Siliziumkarbid gefertigt.

Um eine möglichst gute Wärmeanbindung zwischen den Platinen 44, 45 und dem Kontrollgehäuse 41 zu gewährleisten, werden die Platinen - wie in Fig.4 gezeigt - unmittelbar an dem Kontrollgehäuse 41 angeordnet, sodass die Platinen 44, 45 in körperlichem Kontakt mit dem Kontrollgehäuse 41 sind. Die Leistungsschalter 420, 422 als Hauptwärmequellen sind dabei in den Bereichen der Platinen 44, 45 angeordnet, die an dem Kontrollgehäuse 41 anliegen. Optional können die an dem Kontrollgehäuse 41 anliegenden Bereiche der Platinen 44, 45 mit einer Kupferfläche und/oder mit einem Wärmeleitpad (Thermal Pad) ausgestaltet sein, um eine noch bessere thermische Kopplung zu erreichen.

Sowohl bezüglich der Motoreinheit 30 als auch bezüglich der Kontrolleinheit 40 können die thermischen Anbindungen zwischen den einzelnen Komponenten sowie die thermische Anbindung an das thermische Trennelement 8a je nach Ausgestaltung noch verbessert werden, indem eine Wärmeleitpaste, beispielsweise eine Thermopaste, zwischen aneinander angrenzenden Komponenten vorgesehen wird.

Bei der Ausgestaltung des thermischen Trennelements 8a als aktives Kühlelement ist in dem thermischen Trennelement 8a mindestens eine Kühlleitung 81 (Fig. 5) angeordnet, die von einem Kühlfluid durchströmbar ist, welches Wärme aus dem thermischen Trennelement 8a abführt. Die Kühlleitung 81 erstreckt sich als durchgängige Leitung von einen ersten Kühlanschluss 811 durch das Innere des thermischen Trennelements 8a bis zu einem zweiten Kühlanschluss 812, durch welche das Kühlfluid in die Kühlleitung 81 einbringbar bzw. aus der Kühlleitung 81 abführbar ist. Die Kühlanschlüsse 811, 812 sind jeweils an der äusseren Umfangsfläche des thermischen Trennelements 8a vorgesehen, sodass das Kühlfluid von ausserhalb des Trennelements 8a mittels beispielsweise des ersten Kühlanschlusses 811 in die Kühlleitung 81 eingespeist werden kann und mittels des zweiten Kühlanschlusses 812 wieder aus dem Trennelement 8a abgeführt werden kann.

Die Kühlleitung 81 ist so ausgestaltet, dass sie möglichst viele Bereiche des thermischen Trennelements 8a durchläuft, um möglichst effizient eine grosse Wärmemenge abzuführen. Bei der in Fig. 5 mit beispielhaftem Charakter dargestellten Ausgestaltung der Kühlleitung 81 umfasst diese mehrere geradlinige Bohrungen 813, die so angelegt und ausgestaltet sind, dass sie sich zu der durchgängigen Kühlleitung 81 ergänzen, welche die beiden Kühlanschlüsse 811, 812 miteinander verbindet. Jede der Bohrungen 813 wird von der äusseren Umfangsfläche des thermischen Trennelements 8a in das Innere des thermischen Trennelements 8a gebohrt. Anschliessend werden alle Bohrungen 813 ausser den beiden, die an den Kühlanschlüssen 811, 812 beginnen, jeweils an ihrem in der äusseren Umfangsfläche liegenden Ende verschlossen, beispielsweise jeweils mit einer Schraube 814 und einer Dichtung 815, sodass das Kühlfluid nur durch die beiden Kühlanschlüsse 811 und 812 in die Kühlleitung 81 eingebracht bzw. aus der Kühlleitung 81 abgeführt werden kann.

Das Kühlfluid ist vorzugsweise eine Flüssigkeit, beispielsweise Wasser. Ein besonders bevorzugtes Kühlfluid ist demineralisiertes oder deionisiertes Wasser (DI Wasser). DI Wasser ist eine typische Kühlflüssigkeit, welche beispielsweise in den Produktionsanlagen der Halbleiterindustrie häufig verwendet wird.

Das thermische Trennelement 8a ist vorzugsweise aus Stahl, einem Edelstahl oder aus einem rostfreien Stahl gefertigt. Ein solcher Stahl hat auch den Vorteil, dass er korrosionsbeständiger ist als beispielsweise Kupfer. Insbesondere bei der Verwendung von DI Wasser als Kühlfluid, das aggressiver ist als beispielsweise normales Wasser, ist es vorteilhaft, das thermische Trennelement 8a aus einem rostfreien Stahl oder aus einem Edelstahl herzustellen.

Die nach aussen exponierten Flächen des thermischen Trennelements 8a können insbesondere für solche Anwendungen, die eine erhöhte chemische Resistenz erfordern, beschichtet sein, beispielsweise mit einem Epoxidharz (Epoxy), Polytetrafluorethylen (PTFE), Ethylen-Tetrafluorethylen (ETFE) oder einem anderen Kunststoff.

Gleiches gilt für die nach aussen exponierten Flächen aller Komponenten des elektromagnetischen Drehantriebs 1, die aus einem metallischen Werkstoff bestehen, also beispielsweise das Motorgehäuse 20 und das Kontrollgehäuse 41. Diese können in gleicher Weise zur Erhöhung ihrer chemischen Resistenz beschichtet sein.

Im Folgenden wird bezugnehmend auf Fig. 6 die zweite Variante des ersten Ausführungsbeispiels näher erläutert, also diejenige Variante, bei welcher das thermische Trennelement 8b als ein passives thermisches Trennelement 8b ausgestaltet ist, d.h. als ein solches thermisches Trennelement 8b, das nicht von einem Kühlfluid durchströmt wird,. Die im Betrieb generierte Wärme wird hauptsächlich über Konvektion an die Umgebung abgegeben. Fig. 6 zeigt diese zweite Variante des ersten Ausführungsbeispiels in einer schematischen Schnittdarstellung in einem Schnitt in axialer Richtung A.

Bei der folgenden Beschreibung der zweiten Variante wird nur auf die Unterschiede zu der ersten Variante näher eingegangen. Gleiche Teile oder von der Funktion her gleichwertige Teile der zweiten Variante sind mit den gleichen Bezugszeichen bezeichnet wie bei der ersten Variante. Insbesondere haben die Bezugszeichen die gleiche Bedeutung wie sie bereits im Zusammenhang mit der ersten Variante erläutert sind. Es versteht sich, dass alle vorangehenden Erläuterungen bezüglich der ersten Variante in gleicher Weise oder in sinngemäss gleicher Weise auch für die zweite Variante gelten.

Bei der zweiten Variante ist das thermische Trennelement 8b im Wesentlichen ringförmig ausgestaltet (siehe auch Fig. 1) und bildet eine thermische Isolierung zwischen der Motoreinheit 30 und der Kontrolleinheit 40. Das thermische Trennelement 8b ist bezüglich der axialen Richtung A derart zwischen dem Motorgehäuse 20 und dem Kontrollgehäuse 41 angeordnet, dass es einen direkten Kontakt zwischen dem Motorgehäuse 20 und dem Kontrollgehäuse 41 verhindert. Auf der einen Seite liegt das Motorgehäuse 20 an dem thermischen Trennelement 8b an, und auf der anderen Seite liegt das Kontrollgehäuse 41 an dem thermischen Trennelement 8b an.

Vorzugsweise ist der Aussendurchmesser des thermischen Trennelements 8b höchstens so gross wie der Aussendurchmesser des Motorgehäuses 20 oder der Aussendurchmesser des Kontrollgehäuses 41, wobei es ebenfalls bevorzugt ist, dass der Aussendurchmesser des Motorgehäuses 20 zumindest im Wesentlichen gleich gross ist wie der Aussendurchmesser des Kontrollgehäuses 41.

Die schematische Darstellung in Fig. 6 zeigt ein Ausführungsform, bei welcher die Aussendurchmesser des Motorgehäuses 20, des thermischen Trennelements 8b und des Kontrollgehäuses 41 alle im Wesentlichen gleich gross sind. Es sind aber auch solche Ausgestaltungen möglich, bei welchen der Aussendurchmesser des thermischen Trennelements 8b kleiner ist als der Aussendurchmesser des Kontrollgehäuses 41 oder des Motorgehäuses 20. Eine solche Ausgestaltung ist in Fig. 1 veranschaulicht. In derjenigen Stirnfläche des Kontrollgehäuses 41, welche dem thermischen Trennelement 8b zugewandt ist, ist eine im Wesentlichen kreisförmige Gehäuseausnehmung 411 vorgesehen, welche das thermische Trennelement 8b aufnimmt. In sinngemäss gleicher Weise ist in derjenigen Stirnfläche des Motorgehäuses 20, welche dem thermischen Trennelement 8b zugewandt ist, eine im Wesentlichen gleiche Gehäuseausnehmung angeordnet, die jedoch in Fig. 1 nicht zu sehen ist. Die Tiefen der Gehäuseausnehmung 411 und der Gehäuseausnehmung im Motorgehäuse 20, womit ihre jeweilige Erstreckung in axialer Richtung A gemeint ist, sind so bemessen, dass sich das Motorgehäuse 20 und das Kontrollgehäuse 41 im zusammengebauten Zustand nicht berühren, sondern durch einen Luftspalt voneinander getrennt sind. Das bedeutet, dass die Summe aus der Tiefe der Gehäuseausnehmung 411 im Kontrollgehäuse 41 und der Tiefe der Gehäuseausnehmung im Motorgehäuse 20 kleiner ist als die Dicke des ringförmigen thermischen Trennelements 8b, womit seine Erstreckung in axialer Richtung A gemeint ist. Folglich existiert im zusammengebauten Zustand ein ringförmiger Luftspalt zwischen dem Motorgehäuse 20 und dem Kotrollgehäuse 41, welcher zur thermischen Isolation zwischen dem Motorgehäuse 20 und dem Kontrollgehäuse 41 beiträgt.

Es versteht sich, dass diese Ausgestaltung mit der Gehäuseausnehmung 411 im Kontrollgehäuse 41 und mit der Gehäuseausnehmung im Motorgehäuse 20 in sinngemäss gleicher Weise auch bei der ersten Variante realisiert werden kann.

Das thermische Trennelement 8b der zweiten Variante, welches als passives Trennelement zur thermischen Entkopplung der Motoreinheit 30 von der Kontrolleinheit 40 ausgestaltet ist, besteht vorzugsweise aus einem Kunststoff. Insbesondere für Anwendungen in chemisch aggressiven Umgebungen ist ein chemisch resistenter Kunststoff wie beispielsweise Polypropylen bevorzugt.

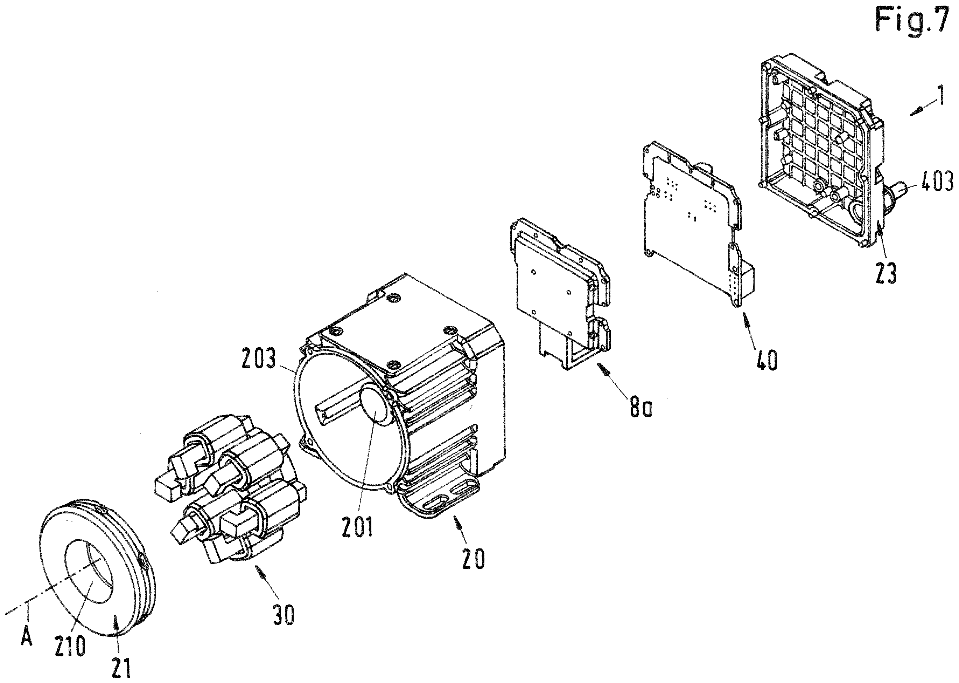

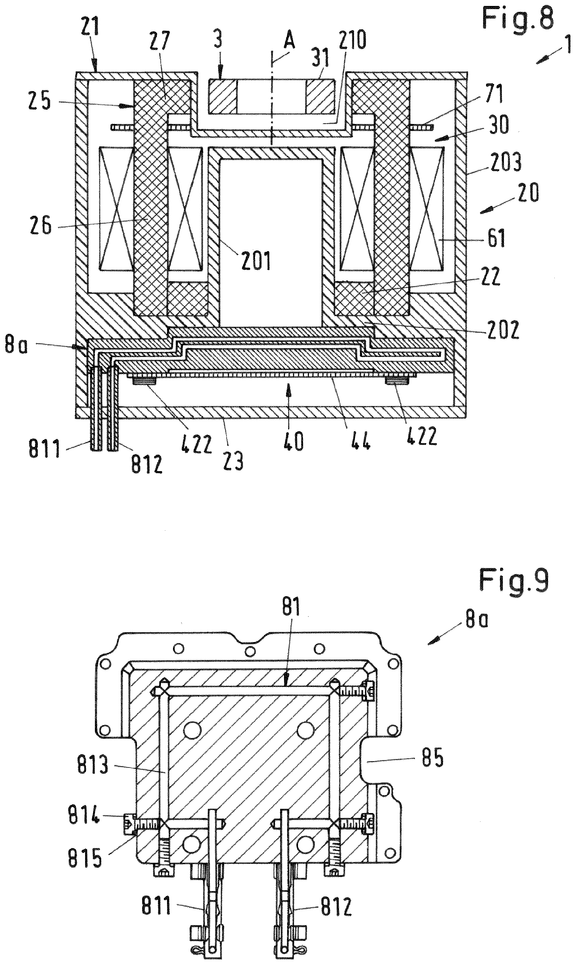

Fig. 7 zeigt eine perspektivische Explosionsdarstellung eines zweiten Ausführungsbeispiels eines erfindungsgemässen elektromagnetischen Drehantriebs 1. Zum besseren Verständnis zeigt Fig. 8 noch eine schematische Schnittdarstellung des zweiten Ausführungsbeispiels in einem Schnitt entlang der axialen Richtung A.

Im Folgenden wird nur auf die Unterschiede zu dem ersten Ausführungsbeispiel eingegangen. Gleiche Teile oder von der Funktion her gleichwertige Teile des zweiten Ausführungsbeispiels sind mit den gleichen Bezugszeichen bezeichnet wie bei dem ersten Ausführungsbeispiel. Insbesondere haben die Bezugszeichen die gleiche Bedeutung wie sie bereits im Zusammenhang mit dem ersten Ausführungsbeispiel erläutert sind. Es versteht sich, dass alle vorangehenden Erläuterungen des ersten Ausführungsbeispiels und seiner beiden Varianten in gleicher Weise oder in sinngemäss gleicher Weise auch für das zweite Ausführungsbeispiel gelten.

Bei dem zweiten Ausführungsbeispiel ist die Kontrolleinheit 40 in dem Motorgehäuse 20 angeordnet, das heisst es ist kein separates Kontrollgehäuse 41 vorgesehen, sondern die Kontrolleinheit 40 befindet sich im Motorgehäuse 20.

Diese konstruktiv etwas einfachere Ausgestaltung des zweiten Ausführungsbeispiels des elektromagnetischen Drehantriebs 1, bei der nur ein gemeinsames Gehäuse vorgesehen ist, nämlich das Motorgehäuse 20, eignet sich insbesondere für kleinere Drehantriebe 1, womit Drehantriebe 1 gemeint sind, die eine weniger hohe Leistung haben, beispielsweise maximal 1000 Watt oder maximal 600 Watt. Bei solchen Leistungen ist es möglich, auf zwei separate, thermisch voneinander getrennte Gehäuse, nämlich eines für die Motoreinheit und eines für die Kontrolleinheit zu verzichten.

Auch bei dieser Ausgestaltung, bei welcher die Kontrolleinheit 40 im Motorgehäuse 20 angeordnet ist, kann das thermische Trennelement 8a, 8b als ein aktives Kühlelement 8a ausgestaltet sein, welches mindestens eine innere Kühlleitung 81 aufweist, die von einem Kühlfluid, beispielsweise Wasser, insbesondere DI Wasser, durchströmbar ist, oder als ein passives Trennelement 8b zwischen der Motoreinheit 30 und der Kontrolleinheit 40, also ohne innere Kühlleitungen.

Fig. 7 und Fig. 8 zeigen eine Ausgestaltung, bei welcher das thermische Trennelement 8a als aktives Kühlelement ausgestaltet ist. Zum besseren Verständnis zeigt Fig. 9 in einer zu Fig. 5 analogen Darstellung dieses thermische Trennelement 8a in einer Schnittdarstellung in einem Schnitt senkrecht zur axialen Richtung A.

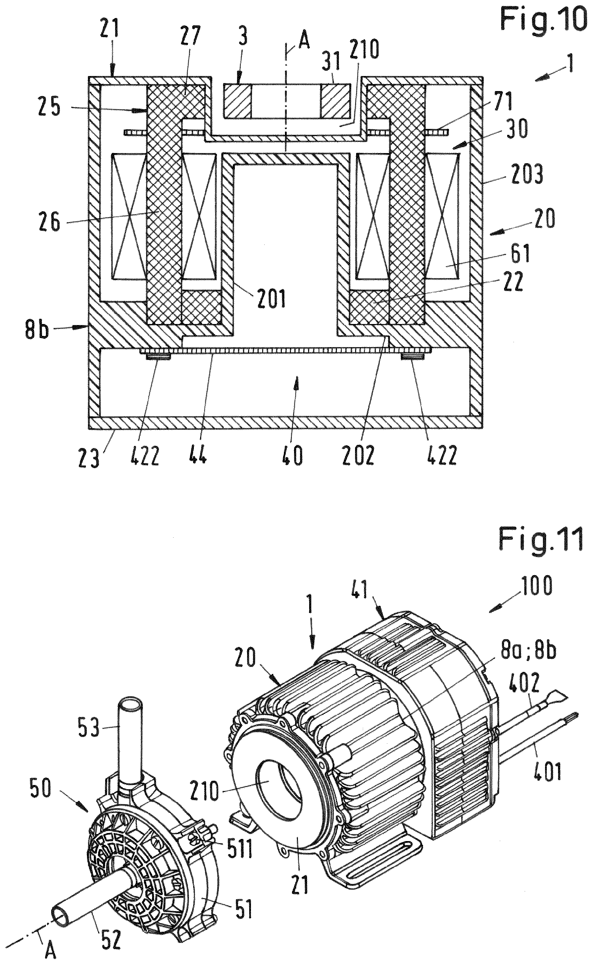

Fig. 10 zeigt in einer schematischen Schnittdarstellung eine Variante des zweiten Ausführungsbeispiels, bei welcher das thermische Trennelement 8b als passives thermisches Trennelement zwischen der Motoreinheit 30 und der Kontrolleinheit 40 ausgestaltet ist.

Bezugnehmend auf die Fig. 7-9 wird nun die Ausgestaltung des zweiten Ausführungsbeispiels beschrieben, bei welcher das thermische Trennelement 8a als aktives Kühlelement ausgestaltet ist.

Wie bereits erwähnt, ist bei dem zweiten Ausführungsbeispiel kein separates Kontrollgehäuse vorgesehen, sondern sowohl die Motoreinheit 30 als auch die Kontrolleinheit 40 sind in dem Motorgehäuse 20 angeordnet. An seinem einen axialen Ende wird das Motorgehäuse 20 durch den Rotorbecher 21 begrenzt, in dessen Ausnehmung 210 der Rotor 3 mit dem magnetisch wirksamen Kern 31 einsetzbar ist.

An dem anderen axialen Ende wird das Motorgehäuse 20 durch einen Gehäusedeckel 23 verschlossen. Der Gehäusedeckel 23 besteht vorzugsweise aus einem Kunststoff. Insbesondere für Anwendungen in chemisch aggressiven Umgebungen ist ein chemisch resistenter Kunststoff wie beispielsweise Polypropylen bevorzugt.

Auch bei dem zweiten Ausführungsbeispiel ist das Motorgehäuse 20 vorzugsweise hermetisch dicht ausgestaltet. Das Motorgehäuse 20 wird dazu an seinen beiden axialen Enden mit dem Rotorbecher 21 und den Gehäusedeckel 23 hermetisch dichtend verbunden, beispielsweise verschraubt. Dabei können Dichtungen, insbesondere Flachdichtungen zwischen dem Motorgehäuse 20 und dem Rotorbecher 21 bzw. dem Gehäusedeckel 23 vorgesehen sein.

Entsprechend einer bevorzugten Massnahme umfasst das Motorgehäuse 20 (siehe insbesondere Fig. 8) einen Innenbecher 201, der im Wesentlichen zylindrisch ausgestaltet ist, und der radial innenliegend bezüglich der Wicklungen 61 in dem von den Wicklungen 61 umgebenen Innenraum angeordnet ist. Der Innenbecher 201 ist über einen flanschartigen Vorsprung 202 mit der äusseren Wandung 203 des Motorgehäuses 20 verbunden. Die äussere Wandung 203 bildet die radial aussenliegende Begrenzung des Motorgehäuses 20. Besonders bevorzugt sind der Innenbecher 201 und der flanschartige Vorsprung 202 integraler Bestandteil des Motorgehäuses 20. Die äussere Wandung 203, der flanschartige Vorsprung 202 und der Innenbecher 201 sind in ihrer Gesamtheit einstückig ausgestaltet und bilden das vorzugsweise einstückige Motorgehäuse 20.

Im Unterschied zum ersten Ausführungsbeispiel ist bei dem zweiten Ausführungsbeispiel das thermische Leitelement 9 nicht vorgesehen. Dafür sind bei dem zweiten Ausführungsbeispiel der Innenbecher 201und der flanschartige Vorsprung 202 vorgesehen, um die von den Wicklungen 61, den Spulenkernen 25 und dem Rückschluss 22 generierte Wärme aufzunehmen. Diese Wärme wird dann mit Hilfe des thermischen Trennelements 8a, das als aktives Kühlelement ausgestaltet ist, abgeführt, wobei ein Teil dieser Wärme auch mittels Konvektion insbesondere über die äussere Wandung 203 des Motorgehäuses 20 abgeleitet wird.

Der flanschartige Vorsprung 202, welcher die äussere Wandung 203 des Motorgehäuses 20 mit dem Innenbecher 201 verbindet, ist bezüglich der axialen Richtung A zwischen den Spulenkernen 25 und dem thermischen Trennelement 8a angeordnet. Der flanschartige Vorsprung 202 ist in sehr gutem Wärmekontakt, vorzugsweise in körperlichen Kontakt, einerseits mit dem thermischen Trennelement 8a und andererseits mit den Spulenkernen 25 oder mit dem Rückschluss 22. Vorzugsweise ist der flanschartige Vorsprung 202 mit den ersten, darstellungsgemäss (Fig. 8) unteren Enden aller Spulenkerne 25 in körperlichem Kontakt und mit dem Rückschluss 22. Besonders bevorzugt liegt der flanschartige Vorsprung 202 über den gesamten Umfang an dem Rückschluss 22 an, um von diesem möglichst gut Wärme aufnehmen zu können. Um den Wärmekontakt zwischen den Spulenkernen 25 bzw. dem Rückschluss 22 und dem flanschartigen Vorsprung 202 noch zu verbessern, ist es möglich, eine Wärmeleitpaste, beispielsweise eine Thermopaste, zwischen dem flanschartigen Vorsprung 202 und den Spulenkernen 25 bzw. dem Rückschluss 22 vorzusehen, welche die aneinandergrenzenden Komponenten besonders gut thermisch miteinander koppelt.

Der mit dem flanschartigen Vorsprung 202 verbundene Innenbecher 201 erstreckt sich von dem radial innenliegenden Rand des flanschartigen Vorsprungs 202 in axialer Richtung A und ist radial innenliegend bezüglich der Wicklungen 61 in dem von den Wicklungen 61 umgegebenen Innenraum angeordnet, wie das insbesondere in Fig. 8 zu erkennen ist. Bezüglich der radialen Richtung ist der Innenbecher 201 möglichst nahe an den Längsschenkeln 26 der Spulenkerne 25 bzw. den darauf angeordneten Wicklungen 61 angeordnet, sodass der Innenbecher 201 die von den Wicklungen 61 und den Spulenkernen 25 generierte Wärme besonders gut aufnehmen und abführen kann. Bezüglich der axialen Richtung A erstreckt sich der Innenbecher 201 etwa bis an das darstellungsgemäss (Fig. 8) obere Ende der Wicklungen 61. Somit erstreckt sich der Innenbecher 201 bezüglich der axialen Richtung A über die gesamte Länge der Wicklungen 61.

Zum Zusammensetzen der Motoreinheit 30 wird das einstückige Motorgehäuse 20, welches den Innenbecher 201, den flanschartigen Vorsprung 202 und die äussere Wandung 203 umfasst, bereitgestellt. Der Stator 2 mit den auf den Spulenkernen 25 angeordneten Wicklungen 61 und der Platine 71 wird in das Motorgehäuse 20 eingesetzt. Anschliessend kann das Motorgehäuse 20 mit der thermischen Vergussmasse aufgefüllt und schliesslich mit dem Rotorbecher 21 dichtend verschlossen werden.

Das thermische Trennelement 8a ist so bemessen, dass es in das Motorgehäuse 20 eingesetzt werden kann. Das thermische Trennelement 8a liegt möglichst grossflächig an dem flanschartigen Vorsprung 202 des Motorgehäuses 20 an, ist also in körperlichem Kontakt mit dem Motorgehäuse 20. Hierdurch wird ein möglichst guter Wärmekontakt zwischen dem flanschartigen Vorsprung 202 und dem thermischen Trennelement 8a realisiert, sodass eine sehr gute Wärmeübertragung von dem flanschartigen Vorsprung 202 bzw. dem Innenbecher 201 in das thermische Trennelement 8a ermöglicht wird.

Zum besseren Verständnis zeigt Fig. 9 eine Schnittdarstellung des thermischen Trennelements 8a des zweiten Ausführungsbeispiels in einem Schnitt senkrecht zur axialen Richtung A. Das thermische Trennelement 8a ist plattenförmig ausgestaltet und hat im Wesentlichen eine rechteckige oder quadratische Form. In dem thermischen Trennelement 8a ist mindestens ein Durchlass 85 vorgesehen, um Signalverbindungen aus der Kontrolleinheit 40 durch das thermische Trennelement 8a hindurch in die Motoreinheit 30 zu führen, beispielsweise elektrische Leitungen zum Versorgen der Wicklungen 61 mit elektrischer Energie.

Wie dies insbesondere Fig. 9 zeigt, liegt das thermische Trennelement 8a an dem flanschartigen Vorsprung 202 des Motorgehäuses 20 an, um eine möglichst gute thermische Anbindung des thermischen Trennelements 8a an den Rückschluss 22, die Wicklungen 61, die Spulenkerne 25 und das Motorgehäuse 20 zu gewährleisten. Hierdurch wird es ermöglicht, dass die im Betrieb im Stator 2 generierte Wärme, die vor allem auf den Eisenverlusten und den Kupferverlusten beruht, effizient und zuverlässig in das thermische Trennelement 8a abgeführt wird.

Auf der der Motoreinheit 30 abgewandten Seite des thermischen Trennelements 8a ist die Kontrollerplatine 44 der Kontrolleinheit 40 angeordnet, die direkt auf dem thermischen Trennelement 8a angeordnet ist, um einen sehr guten Wärmekontakt zwischen der Kontrolleinheit 40 und dem thermischen Trennelement 8a zu gewährleisten. Hierdurch kann die in der Kontrolleinheit 40 generierte Wärme in effizienter Weise in das thermische Trennelement 8a abgeführt werden.

Wie dies in Fig. 9 dargestellt ist, umfasst das thermischen Trennelements 8a, das als aktives Kühlelement ausgestaltet ist, die mindestens eine Kühlleitung 81, die von dem Kühlfluid durchströmbar ist, welches Wärme aus dem thermischen Trennelement 8a abführt. Die Kühlleitung 81 erstreckt sich als durchgängige Leitung von dem ersten Kühlanschluss 811 durch das Innere des thermischen Trennelements 8a bis zu dem zweiten Kühlanschluss 812, durch welche das Kühlfluid in die Kühlleitung 81 einbringbar bzw. aus der Kühlleitung 81 abführbar ist. Die Kühlanschlüsse 811, 812 erstrecken sich jeweils in axialer Richtung A durch den Gehäusedeckel 23 hindurch (siehe Fig. 8), sodass das Kühlfluid von ausserhalb des Motorgehäuses 20 mittels beispielsweise des ersten Kühlanschlusses 811 in die Kühlleitung 81 eingespeist werden kann und mittels des zweiten Kühlanschlusses 812 wieder aus dem Motorgehäuse 20 abgeführt werden kann.

Die Kühlleitung 81 ist so ausgestaltet, dass sie möglichst effizient eine grosse Wärmemenge abführen kann. Bei der in Fig. 9 mit beispielhaftem Charakter dargestellten Ausgestaltung der Kühlleitung 81 umfasst diese mehrere geradlinige Bohrungen 813, die so angelegt und ausgestaltet sind, dass sie sich zu der durchgängigen Kühlleitung 81 ergänzen, welche die beiden Kühlanschlüsse 811, 812 miteinander verbindet. Jede der Bohrungen 813 wird von der Aussenseite des thermischen Trennelements 8a in das Innere des thermischen Trennelements 8a gebohrt. Anschliessend werden alle Bohrungen 813 ausser den beiden, die an den Kühlanschlüssen 811, 812 beginnen, jeweils an ihrem in der Aussenseite des thermischen Trennelements 8a liegenden Ende verschlossen, beispielsweise jeweils mit einer Schraube 814 und einer Dichtung 815, sodass das Kühlfluid nur durch die beiden Kühlanschlüsse 811 und 812 in die Kühlleitung 81 eingebracht bzw. aus der Kühlleitung 81 abgeführt werden kann.

Bei der in Fig. 8 dargestellten Ausgestaltung ist in der Kontrolleinheit 40 wiederum die Kontrollerplatine 44 vorgesehen, Auf der Kontrollerplatine 44 sind diejenigen elektronische Komponenten vorgesehen, welche für die Ansteuerung der Wicklungen 61 zum Realisieren der Antriebs- und der Lagerfunktion benötigt werden. Dies sind insbesondere die Leistungsschalter 422 für die Ansteuerung der Wicklungen 61. Auf der Kontrollerplatine 44 sind ferner Regel- und Steuerkomponenten für die Kontrolle der berührungslosen magnetischen Lagerung und des berührungslosen magnetischen Antriebs vorgesehen sowie optional Auswertekomponenten für Sensorsignale.

Insbesondere bei der Auslegung des Drehantriebs 1 für weniger hohe Leistungen von beispielsweise höchstens 600 Watt, ist es möglich, auf einen in die Kontrolleinheit 40 integrierten Gleichrichter zu verzichten. Dementsprechend ist in der Ausgestaltung gemäss Fig. 8 auch keine Versorgungsplatine 45 vorgesehen. Als Versorgungsspannung wird dann von einer externen Quelle (nicht dargestellt) eine Gleichspannung von beispielsweise 24 Volt oder 48 Volt bereitgestellt. Dazu ist im Gehäusedeckel 23 eine Durchführung 403 (Fig. 8) vorgesehen, durch welche aus einem Versorgungskabel die elektrische Energie in Form der Gleichspannung in die Kontrolleinheit 40 eingespeist werden kann. Die Gleichspannung dient dazu, die für die Leistungsschalter 422 benötigte Zwischenkreisspannung auf der Kontrollerplatine 44 bereitzustellen.

Insbesondere für kleinere Leistungen ist es bevorzugt, die Leistungsschalter 422 mit MOSFETs zu realisieren.

Um eine möglichst gute Wärmeanbindung zwischen der Kontrollerplatine 44 und dem thermischen Trennelement 8a zu gewährleisten, wird die Kontrollerplatine 44 unmittelbar an dem thermischen Trennelement 8a angeordnet, sodass die Kontrollerplatine 44 in körperlichem Kontakt mit dem thermischen Trennelement 8a ist. Die Leistungsschalter 422 als Hauptwärmequellen in der Kontrolleinheit 40 sind somit möglichst nahe an dem thermischen Trennelement 8a angeordnet. Optional können die an dem thermischen Trennelement 8a anliegenden Bereiche der Kontrollerplatine 44 mit einer Kupferfläche und/oder mit einem Wärmeleitpad (Thermal Pad) ausgestaltet sein, um eine noch bessere thermische Kopplung zu erreichen.

Es versteht sich, dass auch solche Ausgestaltungen des zweiten Ausführungsbeispiels des erfindungsgemässen elektromagnetischen Drehantriebs 1 möglich sind, bei denen die Kontrolleinheit 40 in sinngemäss gleicher Weise wie für das erste Ausführungsbeispiel beschrieben einen internen Gleichrichter zur Bereitstellung der Versorgungsspannung umfassen kann. Dieser kann dann auf einer Versorgungsplatine 45 angeordnet sein, in analoger Weise wie dies in Fig. 4 oder in Fig. 6 dargestellt und anhand dieser Fig. 4, Fig. 6 beschrieben ist.

Bezugnehmend auf Fig. 10 wird nun die Variante des zweiten Ausführungsbeispiels erläutert, bei welcher das thermische Trennelement 8b als passives thermisches Trennelement 8b zwischen der Motoreinheit 30 und der Kontrolleinheit 40 ausgestaltet ist, d.h. als ein solches thermisches Trennelement 8b, das nicht von einem Kühlfluid durchströmt wird, sondern die aufgenommene Wärme hauptsächlich über Konvektion an die Umgebung abgibt.

Bei der in Fig. 10 dargestellten Variante des zweiten Ausführungsbeispiels umfasst das thermische Trennelement 8b den Innenbecher 201 und den flanschartigen Vorsprung 202, die vorzugsweise integraler Bestandteil des Motorgehäuses 20 sind. Bevorzugt sind der Innenbecher 201, der flanschartige Vorsprung 202 und die äussere Wandung 203 in ihrer Gesamtheit einstückig ausgestaltet, was eine besonders einfache und kostengünstige Herstellung des Motorgehäuses 20 ermöglicht.

Bei dieser in Fig. 10 dargestellten Ausgestaltung ist das thermische Trennelement 8b somit integraler Bestandteil des Motogehäuses 20. Das thermische Trennelement 8b nimmt sowohl die in der Motoreinheit 30 generierte Wärme als auch die in der Kontrolleinheit 40 generierte Wärme auf, welche dann primär mittels Konvektion über die äussere Wandung 203 des Motorgehäuses 20 an die Umgebung abgegeben wird.

Die Kontrollerplatine 44 ist unmittelbar auf dem flanschartigen Vorsprung 202 angeordnet, sodass die Kontrollerplatine 44 an dem thermischen Trennelement 8b abliegt. Die Leistungsschalter 422 als Hauptwärmequellen in der Kontrolleinheit 40 sind vorzugsweise in den Bereichen der Kontrollerplatine 44 angeordnet, die an dem thermischen Trennelement 8b anliegen.

Durch die Erfindung wird ferner eine Zentrifugalpumpe 100 zum Fördern eines Fluids vorgeschlagen, die dadurch gekennzeichnet ist, dass die Zentrifugalpumpe 100 einen elektromagnetischen Drehantrieb 1 umfasst, der erfindungsgemäss ausgestaltet ist, sowie einen Rotor 3, welcher mit dem elektromagnetischen Drehantrieb 1 zur Rotation antreibbar ist. Der Rotor 3 umfasst einen magnetisch wirksamen Kern 31, welcher in der Ausnehmung 210 im Motorgehäuse 20 angeordnet ist. Der Rotor 3 ist als Rotor 3 der Zentrifugalpumpe 100 ausgestaltet.

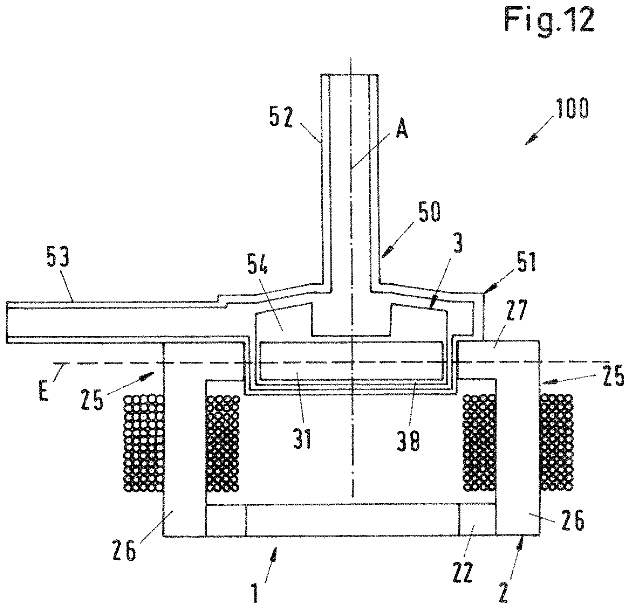

Fig. 11 zeigt ein Ausführungsbeispiel einer erfindungsgemässen Zentrifugalpumpe, die gesamthaft mit dem Bezugszeichen 100 bezeichnet ist, in einer perspektivischen Darstellung. Zum besseren Verständnis zeigt Fig. 12 eine schematische Schnittdarstellung des Ausführungsbeispiels aus Fig. 11 in einem Schnitt in axialer Richtung A. In Fig. 12 sind zum besseren Verständnis das Motorgehäuse 20, die Kontrolleinheit 40 und das thermische Trennelement 8a, 8b nicht dargestellt.

Die Zentrifugalpumpe 100 umfasst eine Pumpeneinheit 50 mit einem Pumpengehäuse 51, das einen Einlass 52 und einen Auslass 53 für das zu fördernde Fluid umfasst, wobei der Rotor 3 im Pumpengehäuse 51 angeordnet ist, und eine Mehrzahl von Flügeln 54 zum Fördern des Fluids umfasst. Die Pumpeneinheit 50 ist derart ausgestaltet, dass die Pumpeneinheit 50 so in die Ausnehmung 210 einsetzbar ist, dass der magnetisch wirksame Kern 31 des Rotors 3 von den Stirnflächen 211 der Querschenkel 27 umgeben wird.

In Fig. 11 ist die Pumpeneinheit 50 getrennt vom Stator 2 dargestellt. Bei dem hier beschriebenen Ausführungsbeispiel der Zentrifugalpumpe 100 ist der elektromagnetische Drehantrieb 1 gemäss dem ersten Ausführungsbeispiel ausgestaltet, weist also das Motorgehäuse 20 und das davon separate Kontrollgehäuse 41 auf, wobei zwischen dem Motorgehäuse 20 und dem Kontrollgehäuse 41 das thermische Trennelement 8a oder 8b angeordnet ist, das als aktives Kühlelement 8a oder als passives thermisches Trennelement 8b ausgestaltet sein kann.

Es versteht sich, dass auch solche Ausgestaltungen der Zentrifugalpumpe 100 möglich sind, bei welchem der elektromagnetische Drehantrieb 1 gemäss dem zweiten Ausführungsbeispiel ausgestaltet ist, bei welchem kein separates Kotrollgehäuse 41 vorgesehen ist, sondern die Kontrolleinheit 40 im Motorgehäuse 20 angeordnet ist.

In der schematischen Darstellung der Fig. 12 ist die Pumpeneinheit 50 in die Ausnehmung 210 (in Fig. 12 nicht dargestellt) und damit in den Stator 2 eingesetzt. Ferner ist in Fig. 12 durch die strichlierte Linie mit dem Bezugszeichen E die radiale Ebene angedeutet, in welcher der magnetisch wirksame Kern 31 des Rotors 3 berührungslos magnetisch gelagert wird.

Ein vorteilhafter Aspekt ist es, dass der Rotor 3 als Integralrotor ausgestaltet ist, weil er sowohl der Rotor 3 für den elektromagnetischen Drehantriebs 1 ist als auch der Rotor 3 der Zentrifugalpumpe 100, mit welchem das Fluid gefördert wird. Insgesamt erfüllt der Rotor 3 somit drei Funktionen in einem: Er ist der Rotor 3 für den elektromagnetischen Drehantrieb 1, er ist der Rotor 3 der magnetischen Lagerung, und er ist das Laufrad, mit welchem auf das Fluid bzw. die Fluide eingewirkt wird. Diese Ausgestaltung als Integralrotor bietet den Vorteil einer sehr kompakten und platzsparenden Ausgestaltung.

Der Stator 2 ist in dem Motorgehäuse 20 angeordnet, das vorzugsweise als hermetisch dichtes Motorgehäuse 20 ausgestaltet ist und den Stator 2 umkapselt. Die Platine 71 ist auch in dem Motorgehäuse 20 angeordnet. Das Statorgehäuse 20 ist vorzugsweise mit einer Vergussmasse, beispielsweise mit einem Epoxidharz oder mit einem Polyurethan, aufgefüllt, sodass der Stator 2 und gegebenenfalls weitere Komponenten, die im Inneren des Motorgehäuses 20 angeordnet sind, von der Vergussmasse umgeben sind.

Das Motorgehäuse 20 weist zudem an seinem der Pumpeneinheit 50 zugewandten Ende die Ausnehmung 210 in dem Rotorbecher 21 auf, sodass die Pumpeneinheit 50 in diese Ausnehmung 210 einsetzbar ist. Der in dem Pumpengehäuse 51 vorgesehene Rotor 3 wird dann von dieser Ausnehmung 210 im Motorgehäuse 20 umschlossen, wobei der magnetisch wirksame Kern 31 des Rotors 3 zwischen den Querschenkeln 27 der Spulenkerne 25 angeordnet ist.

Das Pumpengehäuse 51 ist am Statorgehäuse 20 fixiert, vorzugsweise mit einer Mehrzahl von Schrauben 511.

Die Kontrolleinheit 40 umfasst das Kontrollgehäuse 41, in welchem die verschiedenen elektronischen bzw. elektrischen Komponenten 42 der Kontrolleinheit 40, also insbesondere auch die Kontrollerplatine 44 und die Versorgungsplatine 45, angeordnet sind. Das Kontrollgehäuse 41 ist vorzugsweise als hermetisch dichtes Kontrollgehäuse 41 ausgestaltet, welches die elektronischen Komponenten 42 umkapselt. Das Kontrollgehäuse 41 ist vorzugsweise mit einer Vergussmasse, beispielsweise mit einem Epoxidharz oder mit einem Polyurethan, aufgefüllt, sodass die Platinen 44, 45 und gegebenenfalls weitere Komponenten, die im Inneren des Kontrollgehäuses 41 angeordnet sind, von der Vergussmasse umgeben sind.

In Fig. 11 ist ferner ein Versorgungskabel 401 zum Einspeisen elektrischer Energie in die Kontrolleinheit 40 dargestellt sowie ein Schnittstellenkabel 402 zur Ansteuerung des elektromagnetischen Drehantriebs 1 und/oder zum Datenaustausch. Mit dem Schnittstellenkabel 402 werden beispielsweise Signale zur Ansteuerung einer speicherprogrammierbaren Steuerung (SPS, PLC: Programmable Logic Controller) an die Kontrolleinheit 40 übertragen. Das Versorgungskabel 401 und das Schnittstellenkabel 402 sind über nicht näher dargestellt Durchführungen mit dem Innenraum des Kontrollgehäuses 41 verbunden.

Der Rotor 3 umfasst die Mehrzahl von Flügeln 54 zum Fördern des Fluids. Bei dem hier beschriebenen Ausführungsbeispiel sind beispielsweise insgesamt vier Flügel 54 vorgesehen, wobei diese Anzahl beispielhaften Charakter hat. Der Rotor 3 umfasst ferner eine Ummantelung 38, mit welcher der magnetisch wirksame Kern 31 des Rotors 3 umschlossen und vorzugsweise hermetisch eingekapselt ist, sodass der magnetisch wirksame Kern 31 des Rotors 3 nicht in Kontakt mit dem zu fördernden Fluid kommt. Alle Flügel 54 sind auf der Ummantelung 38 angeordnet und bezüglich der Umfangsrichtung des Rotors 3 äquidistant angeordnet. Jeder Flügel 54 erstreckt sich in radialer Richtung nach aussen und ist drehfest mit dem Ummantelung 38 verbunden. Die Flügel 54 können separate Komponenten sein, die dann auf der Ummantelung 38 fixiert werden. Es ist natürlich auch möglich, dass alle Flügel 54 integraler Bestandteil der Ummantelung 38 sind, dass also die Ummantelung 38 mit allen Flügeln 54 einstückig ausgestaltet ist. Der Rotor 3 mit den Flügeln 54 bildet das Flügelrad bzw. das Laufrad der Zentrifugalpumpe 100, mit welchem auf das Fluid oder die Fluide eingewirkt wird.

Je nach Anwendungsfall, ist es bevorzugt, wenn das Pumpengehäuse 51 der Pumpeneinheit 50 sowie die Ummantelung 38 und die Flügel 54 aus einem oder mehreren Kunststoffen hergestellt werden. Geeignete Kunststoffe sind: Polyethylene (PE), Low Density Polyethylene (LDPE), Ultra Low Density Polyethylene (ULDPE), Ethylene Vinyl Acetate (EVA), Polyethylene Terephthalate (PET), Polyvinylchlorid (PVC), Polypropylene (PP), Polyurethan (PU), Polyvinylidene Fluoride (PVDF), Acrylonitrile Butadiene Styrene (ABS), Polyacryl, Polycarbonate (PC), Polyetheretherketon (PEEK) oder Silicone. Für viele Anwendungen sind auch die unter dem Markennamen Teflon bekannten Materialien Polytetrafluoroethylene (PTFE) und und Perfluoralkoxy-Polymere (PFA) als Kunststoff geeignet.

Es versteht sich, dass der erfindungsgemässe elektromagnetische Drehantrieb auch für andere Vorrichtungen als Zentrifugalpumpen geeignet ist, beispielsweise für Mischvorrichtungen zum Mischen fliessfähiger Substanzen, für Rührvorrichtungen, beispielsweise zum Durchmischen eines Fluids in einem Tank, für Lüfter oder auch für Vorrichtungen zum Tragen und Rotieren von Wafern, beispielsweise in der Halbleiterfertigung.

## Patentansprüche

1. Elektromagnetischer Drehantrieb, der als Tempelmotor ausgestaltet ist, und eine Motoreinheit (30) sowie eine Kontrolleinheit (40) umfasst, wobei die Motoreinheit (30) in einem Motorgehäuse (20) angeordnet ist, welches eine Ausnehmung (210) zum Aufnehmen eines ring- oder scheibenförmigen magnetisch wirksamen Kerns (31) eines Rotors (3) aufweist, wobei die Motoreinheit (30) einen Stator (2) umfasst, welcher als Lager- und Antriebsstator ausgestaltet ist, mit welchem der Rotor (3) im Betriebszustand berührungslos magnetisch um eine Solldrehachse antreibbar ist, die eine axiale Richtung (A) definiert, und mit welchem der Rotor (3) berührungslos magnetisch bezüglich des Stators (2) lagerbar ist, wobei der Rotor (3) in einer zur axialen Richtung (A) senkrechten radialen Ebene aktiv magnetisch gelagert ist, wobei der Stator (2) eine Mehrzahl von Spulenkernen (25) aufweist, von denen jeder einen Längsschenkel (26) umfasst, welcher sich von einem ersten Ende in axialer Richtung (A) bis zu einem zweiten Ende erstreckt, sowie einen Querschenkel (27), welcher an dem zweiten Ende des Längsschenkels (26) und in der radialen Ebene angeordnet ist, und welcher sich von dem Längsschenkel (26) in einer radialen Richtung erstreckt, wobei die Spulenkerne (25) bezüglich einer Umfangsrichtung um die Ausnehmung (210) herum angeordnet sind, und wobei an jedem Längsschenkel (26) mindestens eine konzentrierte Wicklung (61) vorgesehen ist, welche den jeweiligen Längsschenkel (26) umgibt, und wobei die Kontrolleinheit (40) für die Ansteuerung und die Versorgung der Wicklungen (61) mit elektrischer Energie ausgestaltet ist, **dadurch gekennzeichnet, dass** bezüglich der axialen Richtung (A) zwischen der Motoreinheit (30) und der Kontrolleinheit (40) ein thermisches Trennelement (8a; 8b) angeordnet ist, welches an der Motoreinheit (30) und an der Kontrolleinheit (40) anliegt, und welches einen direkten Wärmefluss aus der Motoreinheit (30) in die Kontrolleinheit (40) reduziert.

2. Elektromagnetischer Drehantrieb nach Anspruch 1, wobei in dem thermischen Trennelement (8a) eine Kühlleitung (81) angeordnet ist, die von einem Kühlfluid durchströmbar ist.

3. Elektromagnetischer Drehantrieb nach einem der vorangehenden Ansprüche, bei welchem bezüglich der axialen Richtung (A) zwischen den Wicklungen (61) und den Querschenkeln (27) eine Platine (71) mit elektronischen Komponenten angeordnet ist,

4. Elektromagnetischer Drehantrieb nach einem der vorangehenden Ansprüche, bei welchem die Kontrolleinheit (40) ein separates Kontrollgehäuse (41) umfasst, welches bezüglich der axialen Richtung (A) benachbart zum Motorgehäuse (20) angeordnet ist, wobei das thermische Trennelement (8a; 8b) bezüglich der axialen Richtung (A) zwischen dem Motorgehäuse (20) und dem Kontrollgehäuse (41) angeordnet ist.

5. Elektromagnetischer Drehantrieb nach Anspruch 4, wobei das Motorgehäuse (20) und das Kontrollgehäuse (40) ohne direkten körperlichen Kontakt miteinander angeordnet sind.

6. Elektromagnetischer Drehantrieb nach einem der vorangehenden Ansprüche, wobei der Stator (2) ein thermisches Leitelement (9) mit einer thermischen Leitplatte (91) umfasst, welche bezüglich der axialen Richtung (A) zwischen den Spulenkernen (25) und dem thermischen Trennelement (8a; 8b) angeordnet ist, und welche in körperlichem Kontakt mit den Spulenkernen (25) oder mit einem Rückschluss (22) ist, mittels welchem die ersten Enden aller Längsschenkel (26) zum Führen des magnetischen Flusses verbunden sind.

7. Elektromagnetischer Drehantrieb nach Anspruch 6, wobei das thermische Leitelement (9) eine Mehrzahl von mit der thermischen Leitplatte (91) verbundenen Leitzähnen umfasst, wobei sich jeder Leitzahn (91) jeweils in axialer Richtung (A) erstreckt, und radial innenliegend bezüglich der Wicklungen (61) in dem von den Wicklungen (61) umgebenen Innenraum angeordnet ist.

8. Elektromagnetischer Drehantrieb nach Anspruch 7, wobei jeder Leitzahn (91) bezüglich der radialen Richtung unmittelbar benachbart zu einem der Längsschenkel (26) oder einer der Wicklungen (61) angeordnet ist.

9. Elektromagnetischer Drehantrieb nach einem der Ansprüche 7-8, wobei die Anzahl der Leitzähne (91) gleich der Anzahl der Spulenkerne (25) ist.

10. Elektromagnetischer Drehantrieb nach einem der Ansprüche 7-9, wobei in Umfangsrichtung gesehen zwischen zwei benachbarten Leitzähnen (91) jeweils eine Aussparung (93) vorgesehen ist, die sich bezüglich der axialen Richtung (A) bis in den Bereich der ersten Enden der Längsschenkel (26) erstreckt.

11. Elektromagnetischer Drehantrieb nach einem der Ansprüche 1-3, wobei die Kontrolleinheit (40) in dem Motorgehäuse (20) angeordnet ist.

12. Elektromagnetischer Drehantrieb nach Anspruch 11, wobei das thermische Trennelement (8b) integraler Bestand des Motorgehäuses (20) ist.

13. Elektromagnetischer Drehantrieb nach einen der Ansprüche 11-12, wobei das Motorgehäuse (20) einen Innenbecher (201) umfasst, der im Wesentlichen zylindrisch ausgestaltet ist, und der radial innenliegend bezüglich der Wicklungen (61) in dem von den Wicklungen (61) umgebenen Innenraum angeordnet ist.

14. Elektromagnetischer Drehantrieb nach Anspruch 13, wobei sich der Innenbecher (201) bezüglich der axialen Richtung über die gesamte Länge der Wicklungen (61) erstreckt.

15. Zentrifugalpumpe zum Fördern eines Fluids, **dadurch gekennzeichnet, dass** die Zentrifugalpumpe einen elektromagnetischen Drehantrieb (1) umfasst, der gemäss einem der vorangehenden Ansprüche ausgestaltet ist, sowie einen Rotor (3) mit einem magnetisch wirksamen Kern (31), welcher in der Ausnehmung (210) im Motorgehäuse angeordnet ist, wobei der Rotor (3) als Rotor (3) der Zentrifugalpumpe ausgestaltet ist.
